(19) **Europäisches Patentamt / European Patent Office / Office européen des brevets**

(11) **EP 3 084 959 B1**

(12) **FASCICULE DE BREVET EUROPEEN**

(45) Date de publication et mention
de la délivrance du brevet:
**20.09.2017 Bulletin 2017/38**

(21) Numéro de dépôt: **14827822.9**

(22) Date de dépôt: **11.12.2014**

(51) Int Cl.:
**H03H 17/06** *(2006.01)*

(86) Numéro de dépôt international:
**PCT/FR2014/053285**

(87) Numéro de publication internationale:
**WO 2015/092229 (25.06.2015 Gazette 2015/25)**

(54) **RÉ-ÉCHANTILLONNAGE D'UN SIGNAL AUDIO CADENCÉ À UNE FRÉQUENCE D'ÉCHANTILLONNAGE VARIABLE SELON LA TRAME**

WIEDERABTASTUNG EINES UNTERBROCHENEN AUDIOSIGNALS MIT RAHMENENTSPRECHENDER VARIABLER ABTASTFREQUENZ

RESAMPLING OF AN AUDIO SIGNAL INTERRUPTED WITH A VARIABLE SAMPLING FREQUENCY ACCORDING TO THE FRAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2013 FR 1363322**

(43) Date de publication de la demande:
**26.10.2016 Bulletin 2016/43**

(73) Titulaire: **Orange**
**75015 Paris (FR)**

(72) Inventeurs:
• **RAGOT, Stéphane**
**F-Lannion 22300 (FR)**
• **DANIEL, Jérôme**
**F-22710 Penvenan (FR)**
• **KOVESI, Balazs**
**F-Lannion 22300 (FR)**

(74) Mandataire: **Froger, Marie-Hélène**
**Orange**
**IMTW/OLPS/IPL/PAT**
**Orange Gardens**
**44 Avenue de la République**
**CS 50010**
**92326 Châtillon Cedex (FR)**

(56) Documents cités:
| | |
|---|---|
| WO-A1-91/03790 | WO-A1-2013/142650 |
| US-A1- 2002 099 458 | US-A1- 2004 184 573 |
| US-A1- 2006 214 938 | US-A1- 2007 025 482 |
| US-A1- 2011 054 913 | US-A1- 2013 096 913 |
| US-B1- 6 714 826 | |

**Description**

La présente invention se rapporte au traitement d'un signal audiofréquence pour sa transmission ou son stockage. Plus particulièrement, l'invention se rapporte à un changement de fréquence d'échantillonnage d'une trame à l'autre, notamment lors d'un codage ou d'un décodage du signal audiofréquence.
L'invention s'applique plus particulièrement au cas d'un codage ou d'un décodage par prédiction linéaire dont le codage/décodage de type CELP (pour "Coded Excitation Linear Prediction"). Les codecs par prédiction linéaire, tels que les codecs de type ACELP (pour "Algebraic Coded Excitation"), sont réputés adaptés aux signaux de parole, dont ils modélisent bien la production.

La fréquence d'échantillonnage à laquelle fonctionne l'algorithme de codage CELP est en général prédéterminée et identique dans chaque trame codée ; des exemples de fréquences d'échantillonnage sont :

- 8 kHz dans les codeurs CELP définis dans UIT-T G.729, G.723.1, G.729.1
- 12,8 kHz pour la partie CELP des codeurs 3GPP AMR-WB, UIT-T G.722.2, G.718
- 16 kHz dans les codeurs décrits par exemple dans les articles de G. Roy, P. Kabal, "Wideband CELP speech coding at 16 kbits/sec", ICASSP 1991, et de C. Laflamme et al., 16 kbps "wideband speech coding technique based on algebraic CELP", ICASSP 1991.

Lorsque la fréquence d'échantillonnage du signal à l'entrée ou en sortie du codec n'est pas identique à la fréquence interne de codage CELP, un ré-échantillonnage est nécessaire. Par exemple :

- Dans les codecs 3GPP AMR-WB, UIT-T G.722.2, le signal d'entrée et de sortie en bande élargie est échantillonné à 16 kHz mais le codage CELP fonctionne à la fréquence de 12.8 kHz. On notera que les codecs UIT-T G.718 et G.718 Annexe C fonctionnent également avec des fréquences d'entrée/sortie de 8 et/ou 32 kHz, avec un coeur CELP à 12.8 kHz.
- Dans le codec UIT-T G.729.1, le signal d'entrée est normalement en bande élargie (à 16 kHz) et la bande basse (0-4 kHz) est obtenue par un banc de filtres de type QMF pour obtenir un signal échantillonné à 8 kHz avant codage par un algorithme CELP dérivé des codecs UIT-T G.729 et G.729 Annexe A.

Différentes méthodes de changement de fréquence d'échantillonnage, encore appelé ré-échantillonnage, d'un signal numérique sont connues, en utilisant par exemple et de façon non exhaustive, des opérations de sur et sous-échantillonnage combinées avec un filtrage FIR (pour "Finite Impulse Response" en anglais, ou Réponse Impulsionnelle finie en français), un filtrage IIR (pour "Infinite Impulse response" en anglais, ou Réponse Impulsionnelle infinie en français) ou plus directement une interpolation polynômiale (dont les splines). Une revue des méthodes classiques de ré-échantillonnage se trouve par exemple dans l'article R.W. Schafer, L.R. Rabiner, A Digital Signal Processing Approach to Interpolation, Proceedings of the IEEE, vol. 61, no. 6, June 1973, pp. 692 - 702.

Le document US2006/0214938 A1 décrit un autre exemple de l'état de la technique.

L'avantage du filtrage FIR (symétrique) tient à sa mise en oeuvre simplifiée et - sous certaines conditions - à la possibilité d'assurer une phase linéaire. Un filtrage à phase linéaire permet de préserver la forme d'onde du signal d'entrée, mais il peut aussi s'accompagner d'un étalement temporel (« ringing ») pouvant créer des artéfacts de type pré-échos sur des transitoires. Cette méthode occasionne un retard (qui est fonction de la longueur de la réponse impulsionnelle), en général de l'ordre de 1 à quelques ms pour assurer des caractéristiques de filtrage adéquates (ondulation dans la bande passante, niveau de réjection suffisant pour supprimer le repliement ou les images spectrales...).

L'alternative d'un ré-échantillonnage par filtrage IIR conduit en général à une phase non linéaire, à moins de compenser la phase par un étage supplémentaire de filtrage passe-tout, comme décrit par exemple dans l'article P.A. Regalia, S.K. Mitra, P.P. Vaidyanathan, The Digital All-Pass Filter: A Versatile Signal Processing Building Block, Proceedings of the IEEE, vol. 76, no. 1, Jan. 1988, avec un exemple de réalisation dans la routine 'iirgrpdelay' du logiciel MATLAB; un filtre IIR est en général d'ordre moins élevé mais plus complexe à mettre en oeuvre en virgule fixe, les états (ou mémoires) du filtre pouvant atteindre des valeurs de grande dynamique pour la partie récursive, et ce problème est amplifié si une compensation de phase par filtrage passe-tout est utilisée.

Une technique de ré-échantillonnage est décrite par exemple dans la recommandation UIT-T G.722.2 (encore appelée norme AMR-WB) décrivant les codecs AMR-WB. Dans cette norme, le signal d'entrée échantillonné à 16 kHz est divisé en trames de 20 ms et sous-échantillonné à une fréquence interne de 12.8 kHz avant d'appliquer un codage de type CELP ; le signal décodé à 12.8 kHz est ensuite ré-échantillonné à 16 kHz et combiné avec un signal de bande haute. L'avantage de passer par une fréquence intermédiaire de 12.8 kHz est qu'elle permet de réduire la complexité du codage CELP et aussi d'avoir une longueur de trame qui est une puissance de 2, ce qui facilite le codage de certains paramètres CELP. La méthode utilisée dans AMR-WB est un ré-échantillonnage classique d'un facteur 4/5 par filtrage FIR (avec une réponse impulsionnelle de 121 coefficients à 64 kHz).

En théorie le ré-échantillonnage FIR par un facteur 4/5 dans le codeur AMR-WB peut s'effectuer selon les étapes suivantes :

- Sur-échantillonnage par 4 (de 16 kHz à 64 kHz) par ajout de 3 échantillons à 0 après chaque échantillon d'entrée à 16kHz;
- Filtrage passe-bas à la fréquence de 64kHz par une fonction de transfert $H_{decim}(z)$ de type FIR symétrique d'ordre 120 et de fréquence de coupure proche de 64 kHz ;
- Sous-échantillonnage par 5 (de 64 kHz à 12.8 kHz) en ne gardant qu'un échantillon sur cinq du signal en sortie du filtre $H_{decim}(z)$).

En pratique, ce ré-échantillonnage est mis en oeuvre de façon équivalente dans le codeur AMR-WB suivant une réalisation en polyphase sans calculer le signal intermédiaire à 64 kHz et donc sans rajouter explicitement des zéros au signal à convertir. Pour chaque échantillon à 12,8 kHz en sortie du ré-échantillonnage, un filtrage FIR est appliqué à 16kHz en utilisant une « phase » de la réponse impulsionnelle du filtre $H_{decim}(z)$, ce qui est équivalent à un filtre FIR d'ordre 30 à 16 kHz avec un retard de 15 échantillons à 16 kHz, soit 0.9375 ms.

On s'intéresse ici à une catégorie de codecs supportant au moins deux fréquences d'échantillonnage internes, la fréquence d'échantillonnage pouvant être sélectionnée de façon adaptative dans le temps et variable d'une trame à l'autre. En général, pour une gamme de « bas » débits, le codeur CELP fonctionnera à une fréquence d'échantillonnage moindre, par exemple $fs_1$ =12,8kHz et pour une gamme de débits plus élevés, le codeur fonctionnera à une fréquence supérieure, par exemple $fs_2$ =16kHz. Un changement de débit au cours du temps, d'une trame à une autre, pourra dans ce cas occasionner une commutation entre ces deux fréquences ($fs_1$ et $fs_2$) selon la gamme de débits couverts. Cette commutation de fréquences entre deux trames peut occasionner des artéfacts audibles et gênants, en particulier parce que les mémoires de ré-échantillonnage doivent être correctement définies et celles-ci ne sont pas directement accessibles lorsque la fréquence du signal d'entrée du ré-échantillonnage est variable.

Lorsque la fréquence interne de décodage CELP est différente de la fréquence de sortie, un ré-échantillonnage du signal synthétisé par le décodeur CELP devra ensuite être effectué vers une fréquence de sortie commune du codec $fs^{out}$, définie pour la durée de la séquence codée (ou de la communication).

Or, les méthodes de ré-échantillonnage existantes dans l'état de l'art sont définies en général entre des fréquences fixes avant et après ré-échantillonnage. Ces méthodes ne permettent pas de réaliser un ré-échantillonnage d'un signal où la fréquence avant et/ou après ré-échantillonnage est variable par trame et notamment le cas où un ré-échantillonnage à une première fréquence sur une trame de signal est effectué alors que la trame précédente a une fréquence d'échantillonnage différente de la première.

Il existe donc un besoin d'assurer un ré-échantillonnage optimal (sans artefacts audibles et gênants) de chaque trame dans le cas d'un codec ayant au moins deux fréquences d'échantillonnage différentes.

La présente invention vient améliorer la situation de l'état de l'art.

Elle propose à cet effet, un procédé de ré-échantillonnage d'un signal audiofréquence à une fréquence d'échantillonnage de sortie, pour une trame courante de signal. Le procédé s'applique dans le cas où la trame précédente est échantillonnée à une première fréquence d'échantillonnage différente d'une deuxième fréquence d'échantillonnage de la trame courante, et est tel qu'il comporte les étapes suivantes:

- détermination d'un premier segment de signal par ajout d'un premier nombre prédéterminé d'échantillons à zéro à la fin d'échantillons mémorisés de la trame précédente
- obtention du premier segment ré-échantillonné par application sur le premier segment d'au moins un filtre de ré-échantillonnage ré-échantillonnant de la première fréquence à la fréquence de sortie;
- détermination d'un second segment de signal par ajout d'un second nombre prédéterminé d'échantillons à zéro au début d'échantillons de la trame courante;
- obtention du second segment ré-échantillonné par application au second segment d'au moins un filtre de ré-échantillonnage ré-échantillonnant de la deuxième fréquence à la fréquence de sortie;
- combinaison de la partie en recouvrement des premier et second segments ré-échantillonnés pour obtenir au moins une partie de la trame courante ré-échantillonné.

Ainsi, la commutation entre la trame courante et la trame précédente échantillonnées à des fréquences différentes est effectuée de façon à éviter les artefacts gênants. En effet, la combinaison de segments prenant en compte à la fois le ré-échantillonnage d'une partie du signal de la trame précédente et du signal de la trame courante permet d'obtenir cette transition douce.

Les différents modes particuliers de réalisation mentionnés ci-après peuvent être ajoutés indépendamment ou en combinaison les uns avec les autres, aux étapes du procédé de ré-échantillonnage défini ci-dessus.

Dans un mode de réalisation particulier, dans le cas où la première fréquence d'échantillonnage est inférieure à la deuxième fréquence d'échantillonnage, l'obtention du second segment ré-échantillonné comporte les étapes suivantes:

- obtention d'un segment de transition par ré-échantillonnage de la deuxième fréquence à la fréquence de sortie, du second segment, sur une bande de fréquence limitée;
- obtention d'un second segment ré-échantillonné intermédiaire par ré-échantillonnage de la deuxième fréquence à la fréquence de sortie, du second segment;
- application d'une fonction de fondu enchainé sur au moins une partie des segments de transition et intermédiaire.

Ainsi, la commutation entre des largeurs de bande de fréquences différentes n'est pas effectuée de façon brusque, le fondu enchainé entre des segments ré-échantillonnés permet une transition douce pour passer d'une largeur de bande à une autre.

Dans une variante de réalisation, particulièrement adapté au cas où le ré-échantillonnage est effectué par banc de filtre, dans le cas où la première fréquence d'échantillonnage est inférieure à la deuxième fréquence d'échantillonnage, l'obtention du second segment ré-échantillonné comporte les étapes suivantes:

- obtention d'une division en sous-bande dans au moins le second segment;
- application d'une fonction de pondération sur au moins une sous-bande du second segment ;
- obtention du second segment ré-échantillonné par recombinaison des sous-bandes comportant au moins celle pondérée.

De la même façon, dans le cas où la première fréquence d'échantillonnage est supérieure à la deuxième fréquence d'échantillonnage, l'obtention du premier segment ré-échantillonné comporte les étapes suivantes:

- obtention d'un segment de transition par ré-échantillonnage de la première fréquence à la fréquence de sortie, du premier segment, sur une bande de fréquence limitée;
- obtention d'un premier segment ré-échantillonné intermédiaire par ré-échantillonnage de la première fréquence à la fréquence de sortie, du premier segment;
- application d'une fonction de fondu enchainé sur au moins une partie des segments de transition et intermédiaire.

Dans un mode avantageux de réalisation, le procédé comporte une étape de multiplication de la trame courante ré-échantillonné résultante de l'étape de combinaison, par un signal de pondération.

Ainsi, le signal de pondération permet de compenser la fluctuation d'énergie qui a pu intervenir lors des étapes de ré-échantillonnage.

L'invention s'applique également à un procédé de décodage d'une trame courante d'un signal audiofréquence comportant une étape de sélection d'une fréquence d'échantillonnage de décodage, tel que, dans le cas où la trame précédente est échantillonné à une première fréquence d'échantillonnage différente d'une deuxième fréquence d'échantillonnage de la trame courante, le procédé comporte un ré-échantillonnage tel que décrit précédemment.

L'invention se rapporte à un dispositif de ré-échantillonnage d'un signal audiofréquence à une fréquence d'échantillonnage de sortie, pour une trame courante de signal. Le dispositif s'applique dans le cas où la trame précédente est échantillonnée à une première fréquence d'échantillonnage différente d'une deuxième fréquence d'échantillonnage de la trame courante, et:

- un module de détermination d'un premier segment de signal par ajout d'un premier nombre prédéterminé d'échantillons à zéro à la fin d'échantillons mémorisés de la trame précédente;
- un module de ré-échantillonnage apte à obtenir un premier segment ré-échantillonné par application sur le premier segment d'au moins un filtre de ré-échantillonnage ré-échantillonnant de la première fréquence à la fréquence de sortie;
- un module de détermination d'un second segment de signal par ajout d'un second nombre prédéterminé d'échantillons à zéro au début d'échantillons de la trame courante;
- un module de ré-échantillonnage apte à obtenir un second segment ré-échantillonné par application au second segment d'au moins un filtre de ré-échantillonnage ré-échantillonnant de la deuxième fréquence à la fréquence de sortie; et
- un module de combinaison apte à combiner la partie en recouvrement des premier et second segments ré-échantillonnés pour obtenir au moins une partie de la trame courante ré-échantillonné.

Ce dispositif présente les mêmes avantages que le procédé décrit précédemment, qu'il met en oeuvre.

La présente invention vise également un décodeur de signal audiofréquence comportant un module de sélection d'une fréquence d'échantillonnage de décodage et au moins un dispositif de ré-échantillonnage tel que décrit.

L'invention vise un programme informatique comportant des instructions de code pour la mise en oeuvre des étapes du procédé de ré-échantillonnage tel que décrit, lorsque ces instructions sont exécutées par un processeur.

Enfin l'invention se rapporte à un support de stockage, lisible par un processeur, intégré ou non au dispositif de ré-échantillonnage, éventuellement amovible, mémorisant un programme informatique mettant en oeuvre un procédé de ré-échantillonnage tel que décrit précédemment.

D'autres caractéristiques et avantages de l'invention apparaîtront plus clairement à la lecture de la description suivante, donnée uniquement à titre d'exemple non limitatif, et faite en référence aux dessins annexés, sur lesquels :

- la figure 1 illustre un exemple de codeur comportant des modules de codage fonctionnant à des fréquences d'échantillonnage différentes ainsi que des dispositifs de ré-échantillonnage;
- la figure 2 illustre un exemple de décodeur comportant des modules de décodage fonctionnant à des fréquences d'échantillonnage différentes, et des dispositifs de ré-échantillonnage selon un mode de réalisation de l'invention;
- la figure 3 illustre sous forme d'organigramme un procédé de ré-échantillonnage selon un premier mode de réalisation de l'invention;
- la figure 4 illustre un exemple de ré-échantillonnage selon le premier mode de réalisation de l'invention;
- les figures 5a et 5b illustrent sous forme d'organigramme, les étapes d'un mode de réalisation particulier d'obtention d'un premier segment ou d'un deuxième segment selon l'invention;
- les figures 6a à 6d illustrent les caractéristiques (amplitude ou énergie) de différents signaux qui interviennent lors du fondu enchaîné selon l'invention dans le cas où la première fréquence d'échantillonnage est supérieure à la deuxième fréquence d'échantillonnage;
- la figure 7 illustre l'amplitude des différents segments additionnés lors d'une transition d'une fréquence d'échantillonnage à une autre selon un mode de réalisation de l'invention;
- la figure 8 illustre sous forme d'organigramme un procédé de ré-échantillonnage selon un deuxième mode de réalisation de l'invention;
- la figure 9 illustre un exemple de ré-échantillonnage selon le deuxième mode de réalisation de l'invention;
- la figure 10 illustre sous forme d'organigramme une variante de l'invention, dans le cas d'un ré-échantillonnage par banc de filtres; et
- la figure 11 illustre une représentation matérielle d'un dispositif de ré-échantillonnage selon un mode de réalisation de l'invention.

Par convention les fréquences d'échantillonnage externes aux codecs sont notées avec un exposant (ex : $fs^{in}$, $fs^{out}$) et les fréquences d'échantillonnage internes sont notées avec un indice (ex : $fs_1$, $fs_1$, $fs_{old}$, $fs_{new}$).

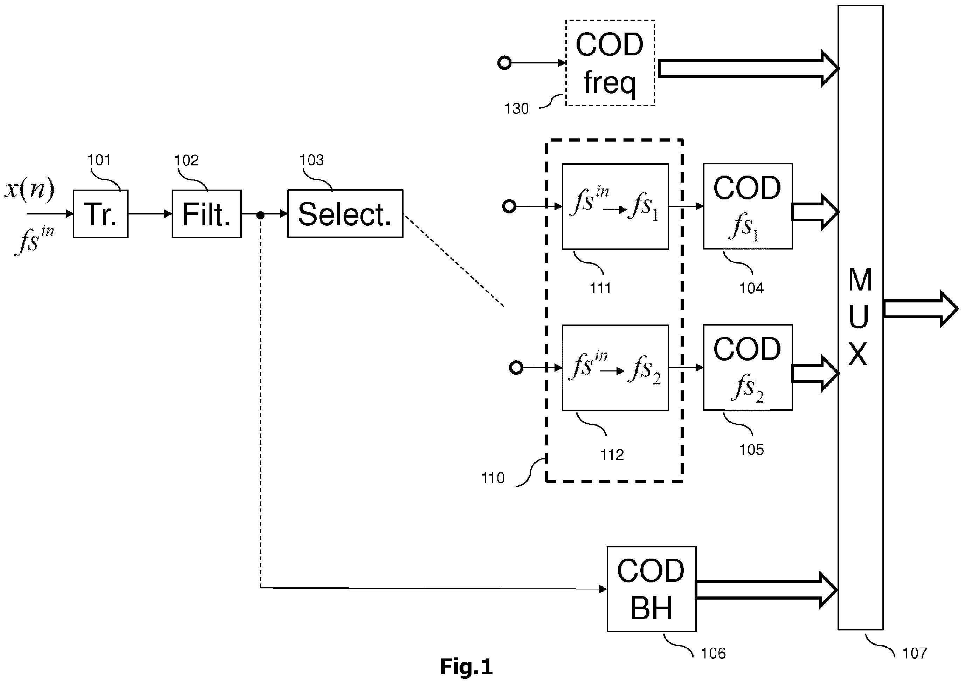

La **figure 1** décrit un exemple de codeur dans lequel au moins un dispositif de ré-échantillonnage est intégré. Le signal d'entrée $x(n)$ (mono) est cadencé à la fréquence $fs^{in}$,

où $fs^{in}$ peut prendre les valeurs de 8, 16, 32 ou 48 kHz.

Ce signal d'entrée est divisé (bloc 101) en trames de 20 ms qui sont traitées séquentiellement. Chaque trame du signal d'entrée est éventuellement filtrée par un filtre passe-haut 102 pour éliminer la composante continue (en général un filtre IIR d'ordre 1 ou 2 avec une fréquence de coupure autour de 50 Hz), puis un ré-échantillonnage est appliqué pour trouver un signal « bande-basse », qui peut être échantillonné à la fréquence fs₁ et/ou à la fréquence $fs_2$. Dans le mode de réalisation décrit ici, $fs_1$ = 12,8 kHz et $fs_2$ = 16 kHz.

Dans un mode possible de réalisation, pour faciliter la gestion des mémoires de ré-échantillonnage au codeur, les deux opérations de sous-échantillonnage 111 et 112 du dispositif de ré-échantillonnage 110 sont effectuées en parallèle pour chaque trame. Cependant lorsque le ré-échantillonnage se fait en utilisant un filtrage de type FIR (Finite Impulse Response en anglais) ou un banc de filtre dont les états sont déterminés à partir des derniers échantillons de la trame précédente de signal d'entrée passé, il est possible de n'effectuer qu'une seule opération (par trame) vers la fréquence $fs_1$ ou $fs_2$ selon la trame courante à coder - en effet, avec un filtrage de type FIR ou un banc de filtre avec des états adaptés, il est possible d'obtenir le signal passé à la fréquence commune $fs^{in}$, et il suffit alors de mettre à jour la mémoire de filtrage ou du banc de filtre en cas de commutation de fréquence interne selon le signal passé. Dans ce cas, un module de sélection 103, permet de choisir quelle opération de ré-échantillonnage 111 ou 112 est à effectuer en fonction de la trame courante à traiter.

On notera également que dans le cas particulier où $fs^{in}$ =8 kHz, seule la fréquence $fs_1$ = 12,8 kHz pourra être utilisée, puisqu'elle suffit à couvrir la bande à coder (0-4 kHz) et il n'est pas nécessaire de recourir à la fréquence $fs_2$ = 16 kHz. On garde cependant la terminologie de signal « bande-basse » pour le signal ré-échantillonnée avec une entrée à 8 kHz.

Par ailleurs, pour les fréquences d'entrée $fs^{in}{\geq}16$ kHz, le codeur peut calculer un signal de bande haute afin de transmettre des paramètres d'extension de bande après codage en 106 - le seul cas où un tel signal bande haute n'est pas calculé correspond au cas où la fréquence interne de codage CELP est sélectionnée à $fs_2$ = 16 kHz pour $fs^{in}$ =16 kHz, car la bande à coder est alors intégralement couverte.

Dans le mode de réalisation décrit ici, on considère que pour les débits <24.4 kbit/s, le codeur sélectionne en 103 $fs_{celp}$ = $fs_1$ = 12,8 kHz et pour les débits ≥24.4 kbit/s, le codeur sélectionne $fs_{celp}$ = $fs_2$ = 16 kHz. Dans des variantes, la sélection de la fréquence interne pourra être mise en oeuvre selon d'autres critères que le débit ou le seuil de 24.4 kbit/s pourra être fixé à une autre valeur.

Dans un mode de réalisation particulier, le ré-échantillonnage en 110 de la fréquence d'entrée $fs^{in}$ à la fréquence interne $fs_1$ et/ou $fs_2$ est effectué par filtre FIR polyphase d'une façon similaire à la réalisation effectuée dans le codec G.718. Les différents filtres FIR utilisés sont précisés au tableau 1 ci-dessous

**Tableau 1**

| Fréquence Interne \d'entrée $fs^{in}$ (kHz) | 8 | 16 | 32 | 48 |
|---|---|---|---|---|
| 12,8 | f_8_120 | f_15_180 | f_15_180 | f_15_180 |
| 16 | Cas non utilisé | Décalage uniquement | f_12_180 | f_12_180 |

où sans perte de généralité, les filtres FIR sont conçus selon la méthode classique dite « méthode de la fenêtre » (car il s'agit du fenêtrage d'un sinus cardinal) comme expliqué ci-dessous.

Par exemple, le filtre f_8_120 est obtenu avec la commande matlab suivante:

$$f\_8\_120 = fir1(240,(3900/32000),hanning(241))*5;$$

avec une fréquence de coupure (-6 dB) à 64 kHz de 3900 Hz.

Ces coefficients sont utilisés comme un filtre de 16 coefficients à 8000 Hz (soit 128 coefficient à 64000Hz) et comme un filtre de 24 coefficient à 12800 Hz(soit 120 coefficients à 64000 Hz, en ignorant les dernières valeurs)

Le filtre f_12_180 est obtenu avec les commandes matlab suivantes:

$$ftmp = fir1(358,1/12,hanning(359));$$

$$f\_12\_180 = [0\ ftmp/ftmp(180)\ 0];$$

avec une fréquence de coupure (- 6 dB) à 192 kHz de 8000 Hz.

Le filtre f_15_180 est obtenu avec les commandes matlab suivantes:

$$ftmp = fir1(358,1/15,hanning(359));$$

$$f\_12\_180 = [0\ ftmp/ftmp(180)\ 0];$$

avec une fréquence de coupure (- 6 dB) à 192 kHz de 6400 Hz.

Le codec étant flexible en termes de débits et de fréquences d'échantillonnage, plusieurs configurations de ré-échantillonnage d'une fréquence $fs_a$ à une fréquence $fs_b$ sont nécessaires. Dans un mode de réalisation décrit ici, les configurations utilisées sont listées dans le tableau 2 ci-dessous :

**Tableau 2**

| Configuration de conversion ($fs_a$ -> $fs_b$) | Filtre FIR utilisé | filt_len (polyphase) | fac_num | fac_den |
|---|---|---|---|---|
| **8000 Hz** -> 12800 Hz | f_8_120 | 15 | 8 | 5 |
| 12800 Hz -> **8000 Hz** | f_8_120 | 24 | 5 | 8 |
| 16000 Hz -> **8000 Hz** | f_12_180 | 30 | 6 | 12 |
| 12800 Hz -> **16000 Hz** | f_15_180 | 12 | 15 | 12 |

(suite)

| Configuration de conversion ($fs_a$ -> $fs_b$) | Filtre FIR utilisé | filt_len (polyphase) | fac_num | fac_den |
|---|---|---|---|---|
| 12800 Hz -> **32000 Hz** | f_15_180 | 12 | 15 | 6 |
| 12800 Hz -> **48000 Hz** | f_15_180 | 12 | 15 | 4 |
| **16000 Hz** -> 12800 Hz | f_15_180 | 15 | 12 | 15 |
| 16000 Hz -> **32000 Hz** | f_12_180 | 15 | 12 | 6 |
| 16000 Hz -> **48000 Hz** | f_12_180 | 15 | 12 | 4 |
| **32000 Hz** -> 12800 Hz | f_15_180 | 30 | 6 | 15 |
| **32000 Hz** -> 16000 Hz | f_12_180 | 30 | 6 | 12 |
| **48000 Hz** -> 12800 Hz | f_15_180 | 45 | 4 | 15 |
| **48000 Hz** -> 16000 Hz | f_12_180 | 45 | 4 | 12 |

Dans ce tableau, les valeurs de fréquences en gras indiquent des fréquences « externes » (c'est-à-dire d'entrée et/ou de sortie) du codec, et les autres valeurs de fréquences sont des fréquences d'échantillonnage « internes » pour le codage de la bande basse du signal. Les valeurs filt_len correspondent au retard de filtrage (et de ré-échantillonnage) par rapport à la fréquence d'entrée du ré-échantillonnage. En général, le retard à la fréquence d'échantillonnage de sortie du ré-échantillonnage est donc l'arrondi à l'entier inférieur de filt_len*fac_num/fac_den, où filt_len est la longueur du filtre (polyphase), fac_num est le facteur de sur-échantillonnage et fac_den est le facteur de sous-échantillonnage. On notera que le retard de ré-échantillonnage est de 0.9375 ms dans toutes les configurations, sauf dans les configurations impliquant la fréquence de 8 kHz - dans ce cas, le retard est deux fois plus long, mais un mécanisme de prédiction combiné au filtrage FIR pourra être utilisé pour réduire ce retard à la même valeur de retard de 0.9375 ms (ce mécanisme n'est pas détaillé ici car il dépasse le cadre de l'invention).
Dans des variantes de l'invention, d'autres méthodes de ré-échantillonnage sont possibles au codeur, en particulier en utilisant d'autres filtres FIR, des filtres IIR au lieu des filtres FIR, ou encore un banc de filtre ou des filtres QMF.

Un codage CELP est ensuite appliqué au signal (« bande basse ») échantillonnée à $fs_1$ ou $fs_2$. Ce codage est effectué soit par le module de codage 104 pour la fréquence d'échantillonnage $fs_1$ soit par le module de codage 105 pour la fréquence d'échantillonnage $fs_2$. Les signaux codés sont ensuite multiplexés en 107 avant d'être transmis ou stockés.

Il est important de souligner ici qu'on suppose que la trame de signal à coder en bande basse par codage CELP à la fréquence $fs_1$ est (temporellement) synchronisée avec la trame de signal à coder en bande basse par codage CELP à la fréquence $fs_2$. Cela implique que les retards de ré-échantillonnage de $fs^{in}$ à $fs_1$ et de $fs^{in}$ à $fs_2$ sont identiques. De plus, les longueurs de signal futur ("*lookahead*" en anglais) des 2 codeurs CELP 104 et 105 aux fréquences $fs_1$ et de $fs_2$ sont identiques. Dans des variantes de l'invention, il est possible de lever ces contraintes d'alignement temporel (sur le "lookahead" et le retard de ré-échantillonnage) en recalant temporellement (avant et/ou après codage) les entrées et /ou synthèses respectives des codeurs CELP 104 et 105, cependant de tels variantes semblent moins avantageuses car elles augmentent forcément le retard global de codage.

Dans le mode de réalisation privilégié, le retard de ré-échantillonnage est de 0.9375 ms et le "lookahead" est fixé à 5 ms pour les 2 codeurs CELP utilisés. Dans des variantes, d'autres valeurs de retard et de longueur de "lookahead" peuvent être utilisées.

Dans un mode de réalisation privilégié, le codeur CELP à la fréquence $fs_1$ = 12,8 kHz (bloc 104) reprend l'algorithme de codage UIT-T G.718, cependant le débit de codage CELP G.718 à 8 kbit/s (fonctionnant à 12,8 kHz) est étendu pour couvrir des débits allant de 7.2 kbit/s à 16.4 kbit/s. Le codage est ainsi effectué sur une version pré-accentuée du signal échantillonné à 12,8 kHz par un filtre de type $1-\alpha_1 z^{-1}$, où $\alpha_1$ = 0,68. Ce codeur fonctionne avec $N_1$=4 sous-trames de 5 ms et 2 filtres LPC d'ordre $M_1$= 16 par trames avec une interpolation du filtre LPC dans le domaine ISF (pour "Imittance Spectral Frequencies" en anglais) sur $N_1$ sous-trames. Dans des variantes, le codeur CELP pourra être dérivé d'un autre codeur, par exemple 3GPP AMR-WB, les paramètres LPC pourront être codés par exemple dans le domaine LSF (pour "Line Spectral Frequencies" en anglais) ; les valeurs de $\alpha_1$, $N_1$, $M_1$ pourront également être différentes ce qui inclut le cas où $\alpha_1$ =0.

Dans le mode de réalisation privilégié, le codeur CELP à la fréquence $fs_2$ = 16 kHz (bloc 105) est une adaptation à 16 kHz du codeur UIT-T G.718, cet algorithme est également étendu pour couvrir des débits allant de 24.4 à 64 kbit/s. avec soit 4 ou 5 sous-trames de longueur identique.

Le codage est ainsi effectué sur une version pré-accentuée du signal échantillonné à 16 kHz par un filtre de

type $1-\alpha_2 z^{-1}$, où $\alpha_2$ = 0,68. Ce codeur fonctionne avec $N_2$=5 sous-trames de 4 ms et 2 filtres LPC d'ordre $M_2$= 16 par trames avec une interpolation du filtre LPC dans le domaine ISF sur $N_2$ sous-trames. Là encore, dans des variantes, le codeur CELP à 16 kHz pourra être différent, les paramètres LPC pourront être codés dans le domaine LSF ; les valeurs de $\alpha_2$, $N_2$, $M_2$ pourront également être différentes, avec par exemple $\alpha_2$ = 0,75, $N_2$=4, $M_2$=18.

On ne s'intéresse pas ici au problème de la mise à jour des états du codeur lors d'une commutation de la fréquence $fs_1$ à la fréquence $fs_2$.

Le codeur selon l'invention prévoit également l'utilisation de modes supplémentaires de codage, tel qu'un codage par transformée fréquentielle (bloc 130).

De même, on notera que des opérations de prétraitement (classification du signal, détection d'activité vocale, etc.) peuvent être mutualisées entre les deux variantes de codage CELP fonctionnant aux fréquences $fs_1$ et $fs_2$, ces opérations ne sont pas décrites en détail ici car elles dépassent le cadre de l'invention.

Dans des variantes de l'invention, d'autres codeurs pourront être utilisés, par exemple des variantes de codage CELP ou de codage selon des modèles de type BroadVoice™ ou SILK connus de l'état de l'art ou encore des codeurs de type transformée.

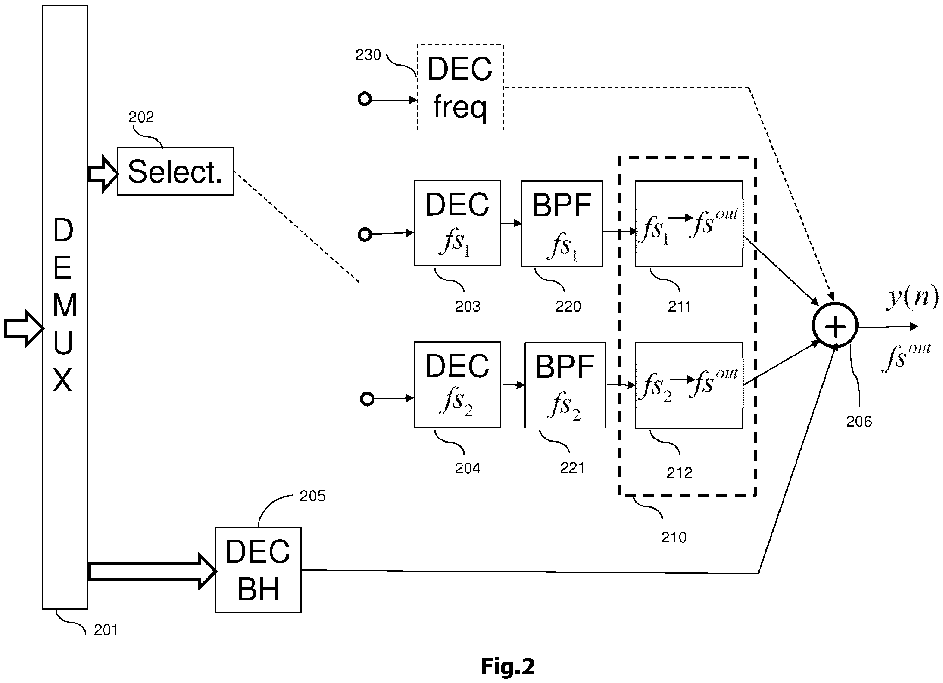

La **figure 2** décrit à présent un exemple de décodeur comportant un dispositif de ré-échantillonnage 210 au sens de l'invention. Le signal de sortie $y(n)$ (mono), est échantillonné à la fréquence $fs^{out}$ qui peut prendre les valeurs de 8, 16, 32 ou 48 kHz.

Pour chaque trame reçue, le train binaire est dé-multiplexé en 201 et décodé. Le décodeur détermine en 202, ici en fonction du débit de la trame courante, à quelle fréquence $fs_1$ ou $fs_2$ décoder les informations du codeur CELP. En fonction de la fréquence d'échantillonnage, soit le module de décodage 203 pour la fréquence $fs_1$ soit le module de décodage 204 pour la fréquence $fs_2$ est mis en oeuvre pour décoder le signal reçu.

De façon similaire au codeur, le décodeur CELP fonctionnant à la fréquence $fs_1$ = 12,8 kHz (bloc 203) est une extension multi-débits de l'algorithme de décodage UIT-T G.718 initialement défini à 8 kbit/s. En particulier il comprend le décodage de l'excitation CELP et un filtrage de synthèse de prédiction linéaire $1/\hat{A}_1(z)$.

Le décodeur CELP fonctionnant à la fréquence $fs_2$ = 16 kHz (bloc 204) est une extension multi-débits à 16 kHz de l'algorithme de décodage UIT-T G.718 initialement défini à 8 kbit/s et à 12,8 kHz.

La mise en oeuvre du décodage CELP à 16 kHz n'est pas détaillée ici car elle dépasse le cadre de l'invention.

On ne s'intéresse pas ici au problème de la mise à jour des états du décodeur CELP lors d'une commutation de la fréquence $fs_1$ à la fréquence $fs_2$.

La sortie du décodeur CELP dans la trame courante est ensuite post-filtrée de façon similaire au « bass post-filter » (BPF) du codec UIT-T G.718 (bloc 220 ou 221), puis ré-échantillonnée à la fréquence de sortie $fs^{out}$, avec par exemple $fs^{out}$ =32 kHz. Ceci revient à effectuer soit un ré-échantillonnage de $fs_1$ à $fs^{out}$, en 211, soit un ré-échantillonnage de $fs_2$ à $fs^{out}$ en 212 dans le dispositif de ré-échantillonnage 210.

On ne s'intéresse pas ici au problème de la mise à jour des états du post-filtre (BPF) lors d'une commutation de la fréquence $fs_1$ à la fréquence $fs_2$.

Dans des variantes, d'autres opérations de post-traitement (filtrage passe-haut, etc.) pourront être utilisées en complément ou en remplacement des blocs 220 et 221.

On notera que le signal en sortie du décodage CELP subit deux retards consécutifs, un retard dû au « bass post-filter » (BPF) puis un retard dû au ré-échantillonnage. Dans des variantes de l'invention, aucun post-filtre tel que réalisé dans le codec G.718 (BPF) ne sera utilisé, ce qui éliminera le retard associé. Dans tous les cas, l'invention est indépendante de l'utilisation d'un post-filtre après décodage aux fréquences $fs_1$ ou $fs_2$.

Alors qu'au codeur les deux opérations de ré-échantillonnage peuvent fonctionner en parallèle avec des états distincts et mis à jour constamment ou lorsqu'une commutation de fréquence interne de codage est observée, au décodeur les deux ré-échantillonnages fonctionnent en alternance et la fréquence d'entrée du ré-échantillonnage n'est pas commune (identique).

De plus, selon la fréquence de sortie $fs^{out}$, un signal bande haute (ré-échantillonné à la fréquence $fs^{out}$) décodé par le module de décodage 205 peut être ajouté en 206 au signal bande basse ré-échantillonné.

Comme pour le codeur, le décodeur prévoit également l'utilisation de modes supplémentaires de décodage, tel qu'un décodage par transformée fréquentielle inverse (bloc 203).

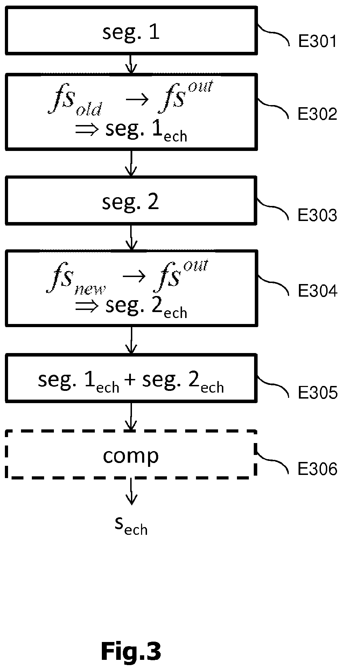

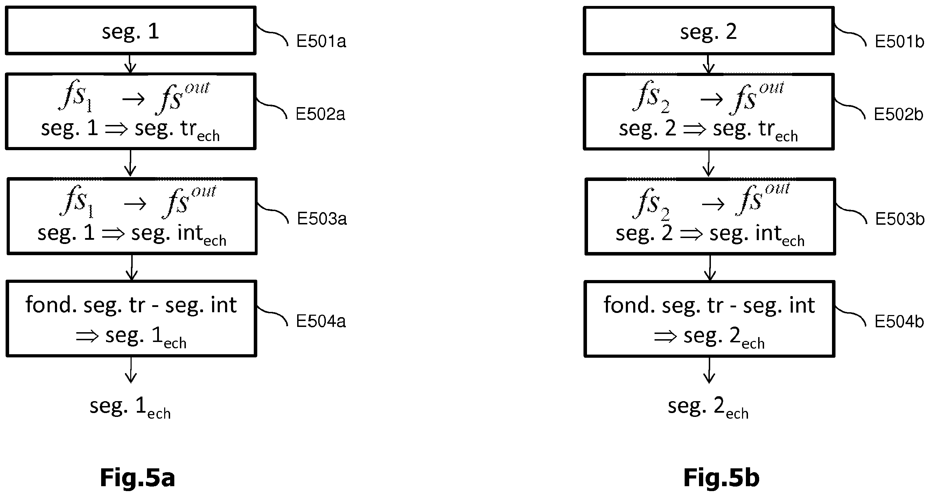

Comme détaillé par la suite en référence à la figure 3 et aux figures 5a et 5b, le dispositif de ré-échantillonnage met en oeuvre un procédé de ré-échantillonnage qui permet d'assurer une continuité des ré-échantillonnages dans chaque trame, évite en particulier des artéfacts de commutation de largeur de bande entre la largeur [0, $fs_1$ /2] et [0, $fs_2$/2] et évite les différences d'énergie à la jonction de deux trames en cas de commutation de fréquence.

La **figure 3** illustre sous forme d'organigramme les étapes mises en oeuvre dans le procédé de ré-échantillonnage selon un mode de réalisation de l'invention. On se place ici dans le cas où la trame précédant la trame courante à traiter est à une première fréquence d'échantillonnage $fs_{old}$ alors que la trame courante est à une deuxième fréquence d'échantillonnage $fs_{new}$. En d'autres termes, dans une application liée au décodage, le procédé selon un mode de réalisation de l'invention, s'applique lorsque la fréquence interne de décodage CELP dans la trame courante ($fs_{new}$) est différente de la fréquence interne de décodage CELP de la trame précédente $(fs_{old})$: $fs_{new} \neq fs_{old}$

Dans un mode général du procédé de ré-échantillonnage selon l'invention, une étape E301 de détermination d'un premier segment de signal est effectuée à partir d'une partie mémorisée de la trame précédente, à la fréquence $fs_{old}$. Pour cela, un premier nombre prédéterminé d'échantillons à zéro est ajouté à la fin des échantillons de la partie mémorisée de la trame précédente. Cet ajout de de zéros est soit explicite en effectuant la concaténation dans un buffer dédié, soit implicite en définissant un signal nul qui complète le signal mémorisé de la trame précédente.

Dans un mode particulier de réalisation, au bloc de fin de trame précédente de longueur $2\,L_{filt}^{old}$, est ajouté un signal futur de longueur $2\,L_{filt}^{old}$ mis à zéro. On notera que la longueur $2\,L_{filt}^{old}$ permet de compenser le retard de filtrage de type FIR ; cette longueur pourra être ajustée si d'autres méthodes de ré-échantillonnage, tel qu'un banc de filtre ou un ré-échantillonnage par filtre IIR, sont utilisées.

Les échantillons mémorisés de la trame précédente constituent les mémoires de ré-échantillonnage, les zéros ajoutés correspondant un à signal « futur » (dans la trame courante) à la fréquence $fs_{old}$. Par exemple en cas de ré-échantillonnage utilisant un filtrage FIR, la longueur de ces mémoires et le nombre prédéterminé d'échantillons à zéro dépend de la longueur de la réponse impulsionnelle du filtre FIR, typiquement ce nombre est égal à la longueur de la réponse impulsionnelle du filtre FIR moins 1.

A l'étape E302, ce premier segment est ré-échantillonné pour le convertir à la fréquence $fs^{out}$ à partir de la fréquence $fs_{old}$, en appliquant en général un sur-échantillonnage, un filtre de ré-échantillonnage et un sous-échantillonnage sur ce segment - cette étape peut être optimisée en utilisant une décomposition polyphase du filtrage et pourra être adaptée en fonction des valeurs des fréquences $fs_{old}$ et $fs^{out}$. pour réaliser cette étape, on utilisera encore l'exemple de mise en oeuvre de ré-échantillonnage par filtre FIR polyphase du codec G.718 (noté modify_fs) avec les filtres FIR définis précédemment aux tableaux 1 et 2.

On obtient alors un premier segment ré-échantillonné (seg.1$_{ech}$) dont $2\,L_{over}$ échantillons sont en général différents de zéro, avec $L_{over} = fs^{out} \cdot L_{filt}^{old} / fs^{old}$. On notera que les premiers $L_{over}$ échantillons en sortie du ré-échantillonnage sont associés à la trame précédente tandis que les $L_{over}$ derniers échantillons sont associés à la trame courante. En fait, à cause du retard de filtrage FIR, le support temporel de la sortie du ré-échantillonnage à l'étape E302 commence après les $L_{filt}^{old}$ premiers échantillons du premier segment seg.1 et se termine avant les $L_{filt}^{old}$ derniers échantillons du premier segment seg.1.

La mémoire de ré-échantillonnage correspond dans ce cas aux $2\,L_{filt}^{old}$ derniers échantillons de la trame précédente après post-filtre (signal en sortie du bloc 220 si $f_s^{old}$ = 12,8 kHz et en sortie du bloc 221 si $fs_{old}$ = 16 kHz). Si $fs_{new}$ = 12,8 kHz , alors $fs_{old}$ = 16 kHz et $L_{filt}^{old} = 15$ ; si $fs_{new}$ = 16 kHz , alors $fs_{old}$ = 12,8 kHz, $L_{filt}^{old} = 12$.

A l'étape E303, on détermine un second segment par ajout d'un second nombre prédéterminé d'échantillons à zéro au début d'échantillons de la trame courante échantillonnée à la fréquence $fs_{new}$. Là encore, cet ajout de zéros est soit explicite en effectuant la concaténation dans un buffer dédié, soit implicite en définissant un signal nul qui complète le signal mémorisé de la trame courante.

Dans un mode particulier de réalisation, on ajoute à la trame courante de longueur $L_{frame}^{new}$ une mémoire du signal passé de longueur $2L_{filt}^{new}$ mise à zéro, pour obtenir le second segment (seg.2) (ce qui correspond à une mémoire mise à 0).

Là encore, on notera que la longueur $2L_{filt}^{new}$ permet de compenser le retard de filtrage de type FIR ; cette longueur pourra être ajustée si d'autres méthodes de ré-échantillonnage sont utilisées.

Ce second segment est ré-échantillonné en E304 pour obtenir un segment à la fréquence d'échantillonnage de sortie $fs^{out}$ à partir de la fréquence $fs_{new}$, en appliquant un filtre de ré-échantillonnage au second segment. On utilisera encore l'exemple de mise en oeuvre de ré-échantillonnage par filtre FIR polyphase du codec G.718 (noté modify_fs) avec les filtres FIR définis précédemment aux tableaux 1 et 2.

On obtient ainsi un second segment ré-échantillonné (seg.2$_{ech}$) dont les premiers $2\,L_{over}$ échantillons correspondent temporairement aux $2\,L_{over}$ échantillons non nuls du premier segment ré-échantillonné. Là encore, à cause du retard de filtrage FIR, le support temporel de la sortie du ré-échantillonnage à l'étape E304 est décalé de $L_{filt}^{new}$ échantillons par rapport au début second segment seg.2 incluant des zéros.

On notera que les premiers $L_{over}$ échantillons en sortie du ré-échantillonnage sont associés à la trame précédente tandis que les $L_{over}$ derniers échantillons sont associés à la trame courante.

L'étape E305, combine la partie en recouvrement des deux segments ré-échantillonnés de longueur $2L_{over}$ pour obtenir la fin de la trame précédente ré-échantillonnée et au moins le début de la trame courante ré-échantillonnée ($s_{ech}$). Ceci permet d'éviter les artefacts qui peuvent apparaitre lors d'une commutation de fréquence entre deux trames. Le procédé ici permet d'effectuer une transition douce entre ces deux fréquences d'échantillonnage d'une trame à l'autre. On notera que pour des raisons d'efficacité il est possible d'étendre la définition du second segment pour inclure l'ensemble de la trame courante et non seulement le début de la trame courante (nécessaire au recouvrement) lors de l'opération de ré-échantillonnage du second segment.

Dans un mode particulier de réalisation, la combinaison (addition-recouvrement) des deux segments ré-échantillonnés à la fréquence $fs^{out}$ s'effectue sur les $2L_{over}$ premiers échantillons, de la façon suivante:

$$s_{ech}(n) = seg.1_{ech}(n) + seg.2_{ech}(n), n = 0, \dots, 2L_{over} - 1$$

où

$$L_{over} = fs^{out}.L_{filt}^{old} / fs^{old}$$

Eventuellement, une étape supplémentaire E306 de correction par mise à l'échelle à l'échantillon est également réalisée pour compenser la fluctuation d'énergie après combinaison :

$$s_{ech}(n) = w_{comp}(n).s_{ech}(n), n = 0, \dots, L_{comp} - 1$$

où $L_{comp} = 2 L_{over}$ et $w_{comp}(n)$ correspond à des facteurs de compensation (ou de pondération) pré-calculés.

Le calcul de $w_{comp}(n)$ est obtenu à l'avance et peut donc être pré-stocké. On peut obtenir ces facteurs de compensation $w_{comp}(n)$ de la façon suivante : on remplace les échantillons d'entrée par une valeur constante fixée à la valeur du facteur de sur-échantillonnage correspondant, par exemple à 5 dans le cas de sur-échantillonnage de 12800 Hz à 64000 Hz et en supposant un filtre FIR de gain égal à 1 (sinon il faut diviser cette constante par le gain du filtre FIR qui est la somme de ces coefficients). Ensuite on applique le ré-échantillonnage sur ce signal ; cette opération est répété pour les deux segments de longueur pré-déterminée les segments ré-échantillonnés sont ensuite combinés et le résultat est ensuite utilisé pour normaliser (diviser) le signal audio ré-échantillonné $s_{ech}(n)$ ou de façon équivalente son inverse est utilisé comme facteurs de compensation multiplicative $w_{comp}(n)$.

Dans le mode de réalisation décrit ci-dessus, les étapes E302 et E304 d'obtention de segment ré-échantillonné par application d'un filtre de ré-échantillonnage sont effectuées par l'application d'un filtre FIR polyphase.

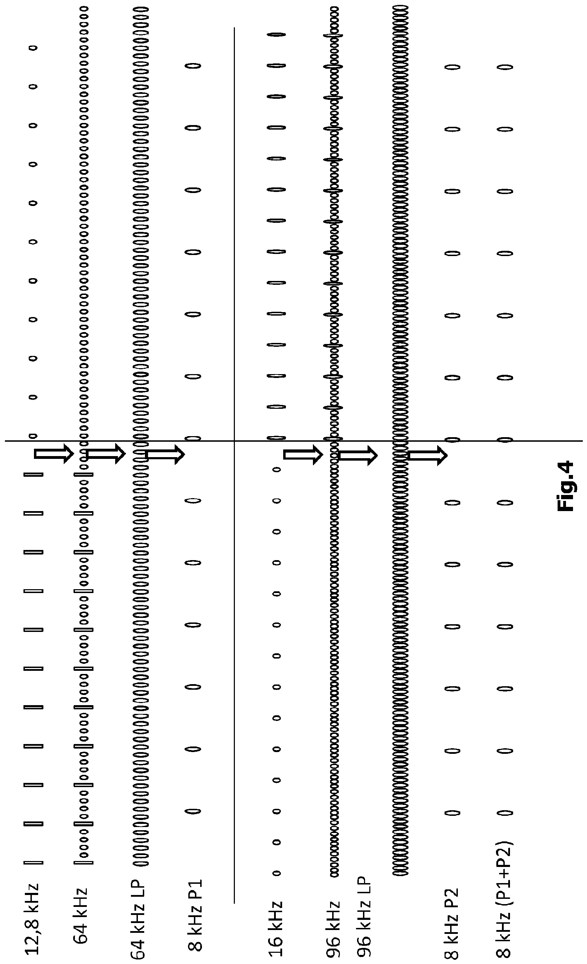

Ces étapes de ré-échantillonnage peuvent être effectuées de la même façon par une décomposition en trois étapes: sur-échantillonnage à une fréquence supérieure, filtrage de type passe-bas puis sous-échantillonnage. Un exemple de réalisation de ce type est illustré à la figure 4.

Ainsi, la **figure 4** illustre un tel ré-échantillonnage où $fs_{old}$ =12,8 kHz, $fs_{new}$ = 16 kHz et $fs^{out}$ = 8 kHz, en utilisant les filtres décrit dans le tableau 1 plus haut. Selon ce tableau, pour le ré-échantillonnage de 12,8 kHz vers 8 kHz, on sur-échantillonne le signal d'entrée par un facteur 5 à 64 kHz (en ajoutant 4 zéros entre les échantillons à 12,8 kHz), on applique ensuite un filtre passe-bas dont la fréquence de coupure est autour de 4 kHz et on sous-échantillonne finalement ce signal par un facteur de 8.

Pour le ré-échantillonnage de 16 kHz vers 8 kHz, on sur-échantillonne le signal d'entrée par un facteur 6 à 96 kHz (en ajoutant 5 zéros entre les échantillons à 16 kHz), on applique le filtre passe-bas dont la fréquence de coupure est autour de 4 kHz et finalement on sous-échantillonne ce signal par un facteur de 12. A noter que dans cette exemple la fréquence de coupure des filtres FIR est identique car $fs^{out} > \min(fs_{new}, fs_{old})$.

Sur la figure 4, on peut voir en haut des symboles carrés symbolisant les échantillons à 12.8 kHz à la fin de la trame précédente, ils constituent également les valeurs non nulles de la mémoire du filtre FIR passe bas. La ligne verticale marque la fin de la trame. Les ronds après la ligne verticale symbolisent les valeurs zéros à la fin du premier segment. Cette première ligne symbolise donc le résultat de l'étape (E301 de la figure 3) de détermination du premier segment. La ligne suivante montre le signal sur-échantillonnée à 64 kHz par ajout de 4 zéros entre les échantillons à 12.8 kHz. Ce signal est ensuite filtré passe-bas (marqué « 64 kHz LP » sur la figure, puis il est sous-échantillonné à 8 kHz en ne gardant qu'un échantillon sur 8. Ce signal est appelé « 8 kHz P1 » sur la figure ; il est la première composante du signal de sortie. Ces trois lignes symbolisent l'étape (E302 de la figure 3) d'obtention du premier segment ré-échantillonné.

Sur la ligne marquée « 16 kHz », les symboles ovales symbolisent les échantillons à 16 kHz au début de la trame courante. Les ronds avant la ligne verticale symbolisent le signal passé (les mémoires du filtre FIR passe-bas) mises à zéros. Cette ligne symbolise donc le résultat de l'étape (E303 de la figure 3) de détermination du second segment.

La ligne suivante montre ce signal sur-échantillonnée à 96 kHz par ajout de 5 zéros entre les échantillons à 16 kHz. Ce signal est ensuite filtré passe-bas (marqué « 96 kHz LP » sur la figure, puis il est sous-échantillonné à 8 kHz en ne gardant qu'un échantillon sur 12. Ce signal est appelé « 8 kHz P2 » sur la figure, il représente la deuxième composante du signal de sortie. Ces trois lignes symbolisent l'étape (E304 de la figure 3) d'obtention du second segment ré-échantillonné.

Finalement ces deux composantes, « 8 kHz P1 » et « 8 kHz P2 » sont combinés pour former le signal de sortie à 8 kHz (étape E305 de la figure 3). Ce signal est éventuellement pondéré ensuite pour égaliser la fluctuation de l'énergie autour de la frontière entre les trames.

De même, dans un autre mode de réalisation, des filtres de ré-échantillonnage différents des filtres polyphases peuvent être utilisés comme des bancs de filtre par exemple de type QMF.

Dans un mode particulier de réalisation, pour un ré-échantillonnage lié à la fréquence de sortie $fs^{out}$ =8 kHz, la mise en oeuvre tient compte de la longueur double des filtres et aussi du fait que la bande est limitée à 4 kHz sans problème de commutation de largeur de bande à partir de la fréquence interne ($fs_1$ et $fs_2$).

Dans un autre mode de réalisation particulier, par exemple, pour les autres fréquences de sortie, $fs^{out}$ = 16, 32, 48 kHz, un fondu enchaîné (« cross-fade ») de deux composantes de bande passante différente est mis en oeuvre pour éviter des artefacts de commutation de largeur de bande entre 6.4 et 8 kHz. Dans des variantes des opérations de pondération pourront être également réalisées sur les segments avant ré-échantillonnage (et non après ré-échantillonnage) pour préparer un fondu enchaîné.

Le mode de réalisation décrit précédemment est détaillé maintenant aux figures 5a et 5b.

La **figure 5a** illustre les étapes mises en oeuvre pour obtenir le premier segment échantillonné (seg.1$_{ech}$), dans le cas où la fréquence d'échantillonnage de la trame précédente est supérieure à la fréquence d'échantillonnage de la trame courante.

Ainsi par exemple, si $fs_1$ = $fs_{old}$ = 16 kHz (et $fs_2$ = $fs_{new}$ = 12,8 kHz), le signal de la trame précédente a une bande de fréquence 0-8000 Hz, tandis que le signal de la trame courante a une bande de fréquence 0-6400 Hz. Pour éviter des défauts de commutation de bande, un fondu enchaîné est appliqué sur le signal associé à la fin de trame précédente c'est-à-dire ici, comme décrit en référence à la figure 3, sur le premier segment. Le ré-échantillonnage pour obtenir le premier segment ré-échantillonné (seg.1$_{ech}$) comprend dans ce cas les étapes suivantes :

- A l'étape E501a. dans ce mode de réalisation, le premier segment est formé du bloc de fin de trame précédente en sortie du post-filtre de longueur $2L_{filt}^{old}$ et d'un signal futur de longueur $2L_{filt}^{old}$ mis à zéro.

- A l'étape E502a, un ré-échantillonnage avec limitation de bande à 6.4 kHz (intégré dans le filtrage FIR de ré-échantillonnage) de la fréquence $fs_{old}$ = 16kHz à la fréquence $fs^{out}$ est mis en oeuvre. Un segment de transition ré-échantillonné seg.tr$_{ech}$ est alors obtenu.

  On utilise ici une mémoire de ré-échantillonnage correspondant aux $2L_{filt}^{old}$ =30 derniers échantillons du signal en sortie du post-filtre dans la trame précédente. Suite à cette étape de ré-échantillonnage, le segment de transition ré-échantillonné seg.tr$_{ech}$ = $s_{ringing}^{6.4kHz}$ de longueur $2L_{over}$ est obtenu.

  Si $fs_{old} \neq fs^{out}$, une autre étape de ré-échantillonnage est effectuée en E503a pour le premier segment tel que défini en E501a. Le ré-échantillonnage s'effectue de la fréquence $fs_{old}$ = 16kHz à la fréquence $fs^{out}$. On obtient alors un segment intermédiaire ré-échantillonné seg.int$_{ech}$ = $s_{ringing}^{8kHz}$ .

  Si $f_{sold}$ = $fs^{out}$, le signal intermédiaire seg.int est défini par les $L_{filt}^{old}$ = 15 derniers échantillons de la mémoire ($L_{filt}^{old}$ = 15 derniers échantillons du signal en sortie du post-filtre dans la trame précédente), suivis de 15 échantillons nuls.

A l'étape E404a, les deux segments, segment de transition (seg.tr$_{ech}$ = $s_{ringing}^{6.4kHz}$) et segment intermédiaire (seg.int$_{ech}$ = $s_{ringing}^{8kHz}$) sont combinés pour effectuer un fondu enchainé, de la façon suivante:

$$seg.1_{ech}(n) = fac(n)s_{ringing}^{6.4kHz}(n) + (1 - fac(n))s_{ringing}^{8kHz}(n), n = 0, \ldots, 2L_{over} - 1$$

où

**EP 3 084 959 B1**

$$(n) = n/L_{over} \ , \ \mathsf{n} = 0, \ ..., \ \mathsf{L_{over}}\text{-}1 \ ;$$

$$\mathsf{fac(n)} = 1, \ \mathsf{n} = \mathsf{L_{over}}, \ ..., \ 2\mathsf{L_{over}}\text{-}1;$$

et

$$L_{over} = fs^{out}.L_{filt}^{old} \ / \ fs^{old} = 15 fs^{out} /16 \ .$$

Dans des variantes d'autres facteurs de pondération que l'exemple de pondération linéaire défini ici, pourront être utilisés.

Le fondu enchainé est fait selon la réalisation privilégié sur la première moitié de la zone de recouvrement. Dans ce cas le calcul de la deuxième moitié du segment intermédiaire $s_{ringing}^{8kHz}$ n'est pas nécessaire (car il a un poids de zéro dans le fondu enchainé).

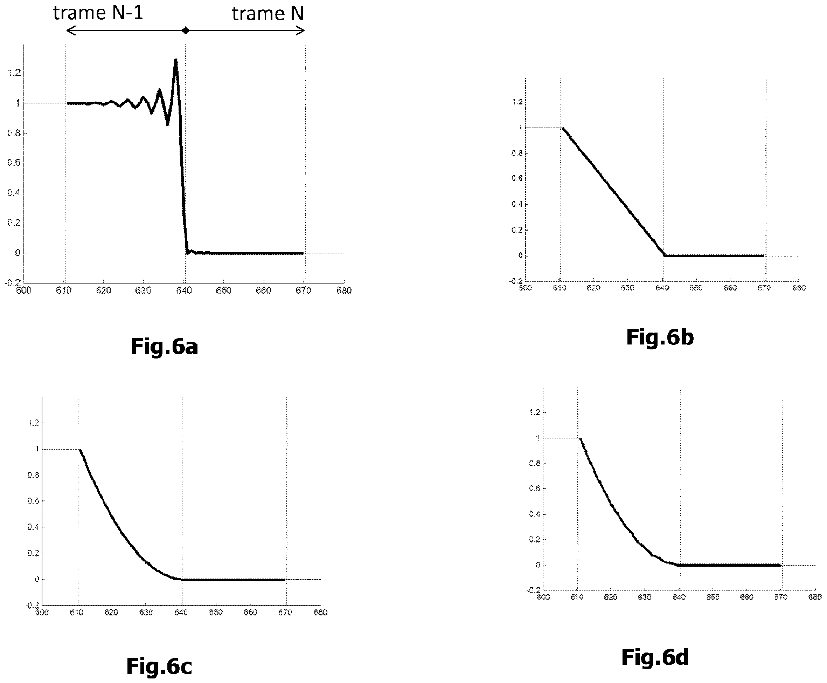

Un exemple de ré-échantillonnage avec $fs_{old}$ = 16 kHz, $fs_{new}$ = 12,8 kHz et $fs^{out}$ = 32 kHz est illustré sur les figures 6a à 6d pour montrer l'évolution de l'énergie des différentes composantes. Comme pour le calcul des facteurs de compensation, chaque échantillon d'entrée a été remplacé par une constante d'une valeur 4 pour l'entrée à 16 kHz et par une constante d'une valeur 5 pour l'entrée à 12800 Hz, pour préserver l'énergie (les gains de filtres ont été normalisés à 1). La **figure 6a** illustre en ligne double largeur l'évolution de l'énergie du segment intermédiaire $s_{ringing}^{8kHz}$ à la fin d'une trame de 640 échantillons, en utilisant le filtre. Avant, jusqu'à l'indice 610 (jusqu'à la première ligne verticale en pointillée) le signal est filtré normalement, sans les zéros ajoutés à la fin de la trame. Le signal ré-échantillonné à $fs^{out}$ = 32 kHz de la partie obtenu avec l'entrée mise à zéro (aussi appelé « ringing »), s'étend donc entre les indices 611 et 670. L'énergie du segment de transition $s_{ringing}^{6.4kHz}$ se comporte de façon très similaire. La deuxième ligne verticale en pointillée correspond à la fin de la trame d'entrée qui sépare la trame précédente (Trame N-1) de la trame courante (Trame N) avec $fs_{old}$ =16 kHz. On observe qu'à cet endroit l'énergie de ce composant filtré chute brusquement. Sans application du fondu enchaîné la bande passante passerait brusquement de 8k Hz à 6,4 kHz ce qui engendrerait des artéfacts audibles. Pour éviter cela et assurer une transition douce de la bande passante il est souhaitable de réaliser un fondu enchainé uniquement sur la première partie (première moitié) du segment intermédiaire $s_{ringing}^{8kHz}$ avec la partie correspondante du segment de transition $s_{ringing}^{6.4kHz}$ . La **figure 6b** illustre une telle fonction de pondération (1-fac(n)) à appliquer sur $s_{ringing}^{8kHz}$ pour réaliser le fondu enchaîné, et la **figure 6c** donne l'énergie de ce signal de pondération. La **figure 6d** trace l'énergie du segment intermédiaire $s_{ringing}^{8kHz}$ après pondération. Ainsi l'énergie de la bande 6,4-8 kHz décroit également graduellement. D'autres types de fondu enchaîné peuvent être également utilisés avec des fenêtres de pondération ayant des définitions différentes sans changer le principe de l'invention.

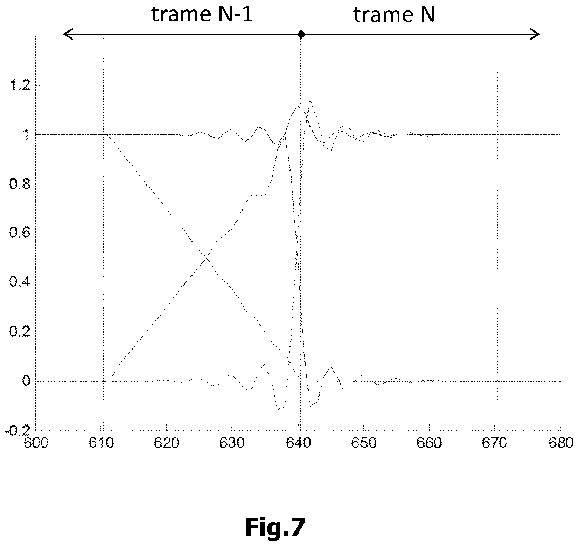

La **figure 7** représente l'amplitude de 3 composantes additionnées lors d'une transition d'une fréquence d'entrée à un autre : en pointillé le segment intermédiaire $s_{ringing}^{8kHz}$ après pondération, en ligne discontinue le segment de transition $s_{ringing}^{6.4kHz}$ après pondération, en tiret-point le premier segment ré-échantillonné seg.$1_{ech}$ et en ligne continue la somme de ces trois segments. Sur cette dernière courbe on peut observer la fluctuation de l'amplitude (et de l'énergie) autour de la frontière des trames, la correction de mise à l'échelle correspond à diviser le signal de sortie par ce signal (ou de façon équivalente à multiplier par l'inverse de ce signal appelé précédemment $w_{comp}(n)$, facteurs de compensation) pour rendre la réponse en énergie plate. Comme expliqué précédemment, on peut obtenir ces facteurs de compensation $w_{comp}(n)$ de la façon suivante : on remplace les échantillons d'entrée par une valeur constante fixée à la valeur du facteur de sur-échantillonnage correspondant, par exemple à 5 dans le cas de sur-échantillonnage de 12800 Hz à 64000 Hz et en supposant un filtre FIR de gain égal à 1 (sinon il faut diviser cette constante par le gain du filtre FIR qui est la somme de ces coefficients). Ensuite on applique le ré-échantillonnage sur ce signal, le signal ré-échantillonné est ensuite utilisé pour normaliser (diviser) le signal audio ré-échantillonné $s_{ech}(n)$ ou de façon équivalente son inverse est utilisé comme facteurs de compensation multiplicative $w_{comp}(n)$. La compensation est en particulier nécessaire lorsque les réponses impulsionnelles de filtres de ré-échantillonnage à la frontière entre trames et en cas de commutation de fréquence interne n'assurent pas une « reconstruction parfaite » et sont temporellement incohérentes ; lorsque le ré-échantillonnage est fait à l'aide d'un banc de filtre ayant des propriétés de reconstruction (quasi-)parfaite (par exemple bancs de filtre QMF ou PQMF), une telle compensation pourrait ne pas être utilisée.

On comprend avec la figure 7 que dans le cas général, en l'absence de compensation (étape E306 de la figure 3), l'invention peut occasionner des modulations d'énergie en cas de commutation de fréquence interne de codage/décodage.

La **figure 5b** illustre les étapes mises en oeuvre pour obtenir le second segment échantillonné (seg.2$_{ech}$), dans le cas où la fréquence d'échantillonnage de la trame précédente est inférieure à la fréquence d'échantillonnage de la trame courante.

Ainsi par exemple, si $fs_1$ = $fs_{old}$ = 12,8 kHz (et $fs_2$ = $fs_{new}$ = 16 kHz), le signal de la trame précédente a une bande de fréquence 0-6400 Hz, tandis que le signal de la trame courante a une bande de fréquence 0-8000 Hz. Pour éviter des défauts de commutation de bande, un fondu enchaîné est appliqué sur le signal associé au début de la trame courante, c'est-à-dire ici, comme décrit en référence à la figure 3, sur le second segment. Le ré-échantillonnage pour obtenir le second segment ré-échantillonné (seg.2$_{ech}$), comprend dans ce cas les étapes suivantes :

- A l'étape E501b. dans ce mode de réalisation, le second segment est formé des $2L_{filt}^{new} = 30$ premiers échantillons de la trame courante (syn) et d'une mémoire du signal passé de longueur $2L_{filt}^{max}$ mise à zéro.

- A l'étape E502b, un ré-échantillonnage avec limitation de bande à 6.4 kHz (intégrée dans le filtre FIR de ré-échantillonnage) de la fréquence $fs_{new}$ = 16kHz à la fréquence $fs^{out}$ est mis en oeuvre.

Suite à cette étape de ré-échantillonnage, un segment de transition ré-échantillonné seg.tr$_{ech}$ est obtenu.

- Une autre étape de ré-échantillonnage est effectuée en E503b pour le second segment tel que défini en E501b. Si $fs_{new} \neq fs^{out}$ le ré-échantillonnage s'effectue de la fréquence $fs_{new}$ à la fréquence $fs^{out}$, pour obtenir un segment intermédiaire Seg.$_{int}$.

Si $fs_{new}$ = $fs^{out}$ = 16 kHz, alors aucun ré-échantillonnage n'est nécessaire, mais un décalage de $L_{filt}^{new} = 15$ échantillons est appliqué au signal en sortie du post-filtre (BPF) pour trouver le segment intermédiaire seg.int$_{ech}$.

- A l'étape E504b, les deux segments, segment de transition (seg.$_{tr}$) et segment intermédiaire (seg.$_{Int}$) sont combinés pour effectuer un fondu enchaîné, de la façon suivante:

$$seg.2_{ech}(n) = fac(n)seg.int._{ech}(n) + \big(1 - fac(n)\big)seg.tr_{ech}(n), n = 0, \ldots, 2L_{over} - 1$$

où

$$fac(n) = 0, n = 0, \ldots, L_{over} - 1$$

$$fac(n) = (n - L_{over} + 1)/L_{over}, n = L_{over}, \ldots, 2L_{over} - 1$$

et

$$L_{over} = fs^{out}.L_{filt}^{old}/fs^{old} = 15fs^{out}/16.$$

Dans des variantes d'autres facteurs de pondération que l'exemple de pondération linéaire défini ici, pourront être utilisés. Le fondu enchaîné est fait selon la réalisation privilégiée sur la deuxième moitié de la zone de recouvrement. Dans ce cas le calcul de la première moitié du segment intermédiaire seg.int$_{ech}$ n'est pas nécessaire (car il a un poids de zéro dans le fondu enchaîné). Pour les raisons de symétrie dans la réalisation privilégiée le fondu enchaîné est fait donc sur L$_{over}$ échantillons. Dans le cas où la fréquence d'échantillonnage de la trame précédente est inférieure à la fréquence d'échantillonnage de la trame courante, on a la possibilité de faire le fondu enchaîné sur un nombre d'échantillons plus importants. Dans ce cas cela prolonge également la génération d'un segment de transition seg.$_{tr}$.

Dans le mode de réalisation décrit ci-dessus, le ré-échantillonnage est effectué au moyen d'un filtrage FIR polyphasé avec un retard associé (0.9375 ms) identique quelque soit la fréquence $fs_1$ ou $fs_2$. Le retard de filtrage FIR est ici de $L_1$ =12 échantillons à la fréquence $fs_1$ et $L_2$ = 15 échantillons à la fréquence $fs_2$.

Dans des variantes utilisant un banc de filtre au lieu du filtrage FIR pour le ré-échantillonnage, le fondu enchaîné en rapport aux figures 5a et 5b pourra être remplacé par une pondération temporelle de sous-bandes adéquates des segments de transition après décomposition en sous-bandes d'au moins les segments de transition, afin de réaliser un démarrage progressif de certaines sous-bandes pour élargir la bande acoustique (en « fade-in » quand $fs_{new} = fs_2 > fs_{old} = fs_1$) ou une atténuation progressive de certaines sous-bandes pour diminuer la bande acoustique (en « fade-out » quand $fs_{new} = fs_1 > fs_{old} = fs_2$).

Dans un deuxième mode de réalisation du procédé de ré-échantillonnage selon l'invention, le ré-échantillonnage ne se fait pas directement par l'utilisation d'un filtre de ré-échantillonnage au moyen d'un filtrage FIR polyphase mais se décompose en un sur-échantillonnage à une fréquence supérieure commune pour les deux trames suivi d'un filtrage passe-bas et d'un sous-échantillonnage. Ce mode de réalisation constitue une solution alternative au problème d'artéfacts audibles qui peuvent apparaitre lors d'une commutation de fréquence d'échantillonnage entre deux trames.

Dans le cas qui nous intéresse ici, la trame précédente est échantillonnée à une première fréquence différente d'une deuxième fréquence d'échantillonnage de la trame courante. Ainsi, lors d'une commutation de la fréquence $fs_1$ (trame N-1) à la fréquence $fs_2$ (trame N courante), les étapes suivantes ont mises en oeuvre :

- Dans la trame précédente (N-1) à la fréquence $fs_1$, jusqu'aux $L_1$ =12 derniers échantillons, un ré-échantillonnage classique par FIR polyphase de la fréquence $fs_1$ à la fréquence $fs^{out}$ est effectué.
- Des $L_1$ derniers échantillons (premier nombre prédéterminé d'échantillons) de la trame précédente jusqu'au $L_2$ =15 premiers échantillons (deuxième nombre prédéterminé d'échantillons) de la trame courante :

   a. Un sur-échantillonnage non-uniforme est réalisé pour atteindre une fréquence intermédiaire commune de ré-échantillonnage.
   Par exemple si $fs^{out}$ =32 kHz, $fs_1$ =12.8 kHz et $fs_2$ = 16kHz, on rajoute 4 zéros après chaque échantillon des 2x $L_1$ = 24 derniers échantillons de la trame précédente, et 3 zéros après chaque échantillon des 2x $L_2$ = 30 premiers échantillons de la trame courante. Ce sur-échantillonnage permet ainsi d'atteindre une fréquence intermédiaire, ici de 64 kHz, qui est commune pour les deux segments associés à des trames différentes.
   b. On applique un filtrage FIR sur la séquence qui est uniformément cadencé à 64 kHz sur (5x2x $L_1$ + 4 x2x $L_2$) échantillons. Dans ce mode de réalisation, et si $fs^{out}$ >min($fs^{new}$, $fs^{old}$), la fréquence de coupure du filtre FIR sur la « partie gauche » est différente de la fréquence de coupure du filtre sur la « partie droite », ce qui implique une commutation du filtre FIR à la même fréquence intermédiaire. Ceci ne pose pas de difficultés de réalisation car la mémoire d'état d'un filtre FIR est le signal d'entrée passé, il suffit de changer simplement les coefficients du filtre. Par contre un changement brusque d'un filtre à une fréquence de coupure de 6,4 kHz à un filtre à une fréquence de coupure de 8 kHz engendrerait un changement brusque de la bande passante et un artefact audible gênant. Il est tout à fait possible d'ajouter les filtres intermédiaires, par exemple un filtre à fréquence de coupure à 7200 Hz pour adoucir ce passage. Si $fs^{out}$ <= min($fs^{new}$, $fs^{old}$) la fréquence de coupure du filtre peut rester constante, typiquement à $fs^{out}$/2.
   c. Une étape de sous-échantillonnage est alors effectuée pour atteindre la fréquence de sortie $fs^{out}$.
   d. Dans un mode particulier, une compensation (par gain temporel) est ajoutée pour égaliser le niveau du signal résultant de l'étape c de sous-échantillonnage. Cette compensation peut être obtenue en remplaçant les échantillons avant sur-échantillonnage à l'étape b par la même valeur fixée à la valeur du facteur de sur-échantillonnage, par exemple à 5 dans le cas de sur-échantillonnage de 12,8 kHz à 64 kHz et en supposant un filtre FIR de gain égal à 1, sinon il faut diviser cette constante par le gain du filtre FIR (qui est la somme de ces coefficients). Ensuite on applique le filtrage FIR de l'étape b à la fréquence intermédiaire sur cette séquence (de 0 et constantes). Le signal est ensuite sous-échantillonné à la fréquence $fs^{out}$. Il est ensuite utilisé pour normaliser (diviser) le signal ou de façon équivalente son inverse est utilisé comme facteurs de compensation multiplicative $w_{comp}(n)$.

- Dans la trame courante (N) après les $L_2$ premiers échantillons, un ré-échantillonnage classique par filtre FIR polyphase de la fréquence $fs_2$ à la fréquence $fs^{out}$ est effectué.

Dans le cas décrit ci-dessus, $fs_1$ est inférieur à $fs_2$. Le principe décrit précédemment s'applique bien évidemment au cas inverse d'une commutation d'une fréquence $fs_1$ (trame N-1) supérieure à la fréquence $fs_2$ (trame N courante).

Ce deuxième mode de réalisation, permet de la même façon que dans le premier mode de réalisation d'assurer une transition douce lors de la commutation d'une fréquence d'échantillonnage à une autre, d'une trame à l'autre. Ce deuxième mode de réalisation a l'avantage de n'utiliser qu'une seule fois un filtre de ré-échantillonnage sur la séquence sur-échantillonnée des échantillons de la trame précédente et de la trame courante. Par contre il nécessite de passer par une fréquence supérieure intermédiaire commune, ce qui n'est pas toujours possible selon les fréquences d'échantillonnage souhaitées. De plus, selon le principe du filtrage polyphasé, la complexité de calcul de ce deuxième mode de réalisation pourra être réduite de façon évidente en ignorant les multiplications avec les échantillons d'entrée de valeur nulle et en ne calculant que les échantillons filtrés qui seront sélectionnés par le sous-échantillonnage. Cette optimisation polyphase n'est pas détaillée car elle est bien connue de l'état de l'art et le ré-échantillonnage par commutation de phase dans les codecs AMR-WB ou G.718 donne un exemple de mise en oeuvre, et le résultat est équivalent à la méthode décrite ci-dessus.

Comme dans le cas du premier mode de réalisation, celui-ci est applicable dans un décodeur comme représenté en figure 2. Le procédé de ré-échantillonnage est mis en oeuvre par le dispositif de ré-échantillonnage 210.

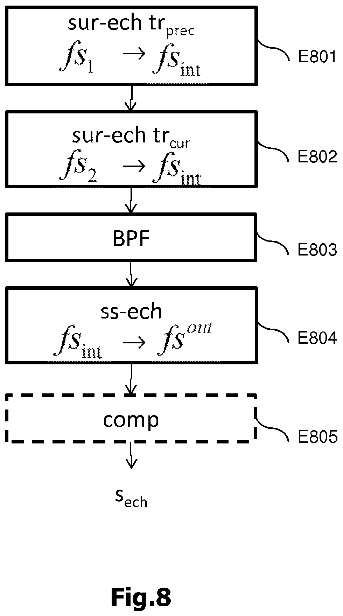

Celui-ci met en oeuvre notamment les étapes suivantes représentées en référence à la **figure 8,** pour une trame courante à une fréquence $fs_2$ et une trame précédente à une fréquence $fs_1$ :

- sur-échantillonnage (E801) à une fréquence intermédiaire commune ($fs_{int}$) d'une partie des échantillons de la trame précédente par ajout d'un premier nombre d'échantillons à zéros;
- sur-échantillonnage (E802) à la fréquence intermédiaire commune d'une partie des échantillons de la trame courante par ajout d'un second nombre d'échantillons à zéros;
- application d'un filtrage passe-bas (E803) au signal sur-échantillonné issu des étapes de sur-échantillonnage, le filtrage comportant éventuellement des fréquences de coupure différentes sur la partie sur-échantillonnée de la trame précédente et celle de la trame courante;
- sous-échantillonnage (E804) du signal filtré pour obtenir une fréquence d'échantillonnage de sortie.

Comme pour le premier mode de réalisation, un signal de pondération peut être appliqué (E805) à la trame courante ré-échantillonné par le procédé décrit ci-dessus, pour compenser la fluctuation d'énergie qui a pu intervenir lors des différentes étapes de ré-échantillonnage.

Dans ce mode de réalisation, la combinaison des signaux issus de la trame précédente et de la trame courante est effectuée à la fréquence commune de ré-échantillonnage avant d'être filtrée par le filtre passe-bas. Cette combinaison permet d'assurer une transition douce.

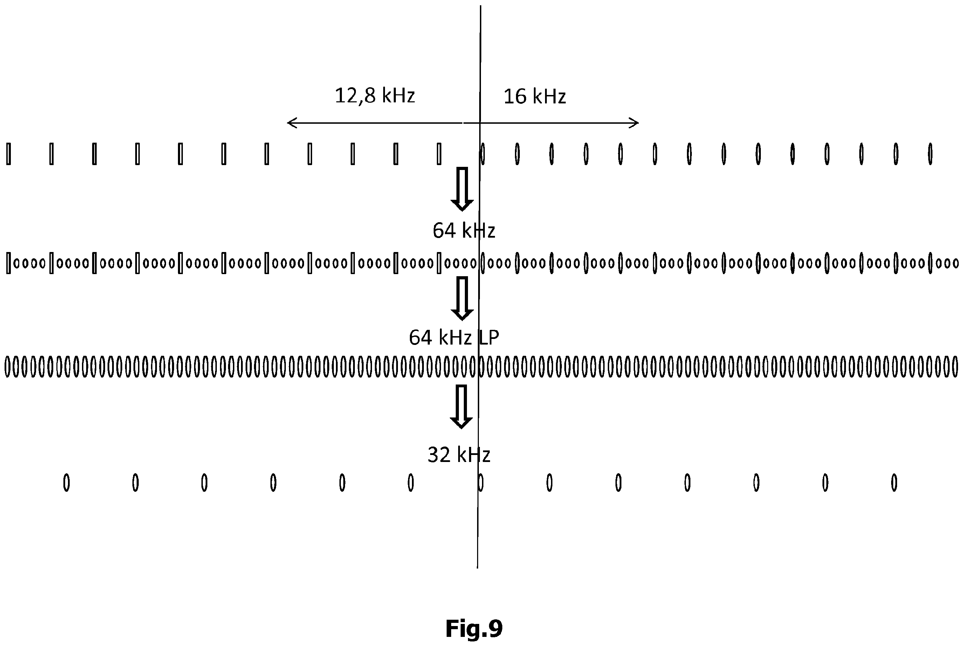

La **figure 9** montre un exemple de cette solution équivalente pour les cas où la fréquence haute après sur-échantillonnage est commune (dans l'exemple donné sur la figure le ré-échantillonnage de 16 kHz vers 8 kHz est fait également en sur-échantillonnant à 64 kHz). La première ligne donne l'emplacement temporaire des échantillons, les symboles carrés symbolisent la fin de la trame précédente à 12.8 kHz, les ovales les échantillons au début de la trame courante à 16 kHz. La deuxième ligne montre ce signal concaténé sur-échantillonné à 64 kHz, en ajoutant 4 zéros après chaque échantillon de la trame précédente (étape E801 de la figure 8) et 3 zéros après chaque échantillon de la trame courante (étape E802 de la figure 8). Ce signal est ensuite filtré par un filtre passe-bas (marqué « 64 kHz LP » sur la figure) (étape E803 de la figure 8), puis il est sous-échantillonné (étape E804 de la figure 8) à 8 kHz en ne gardant qu'un échantillon sur 8. Finalement ce signal est éventuellement pondéré (étape E805 de la figure 8) pour égaliser la fluctuation de l'énergie autour de la frontière entre les trames. A noter que dans cet exemple, comme $fs^{out}$ <=min( $fs^{new}$, $fs^{old}$) la fréquence de coupure du filtre peut rester constante, à 4000 Hz .

Dans des variantes de l'invention, le post-filtre (BPF) en sortie du décodage CELP n'est pas utilisé. La mémoire de ré-échantillonnage est alors obtenue à partir des derniers échantillons de la trame précédente en sortie du décodage CELP au lieu des derniers échantillons de la trame précédente en sortie du post-filtre.

Dans des variantes de l'invention, d'autres décodeurs pourront être utilisés, par exemple des variantes de décodage CELP ou de décodage selon des modèles de type BroadVoice™ ou SILK connus de l'état de l'art ou encore des décodeurs de type transformée.

Dans des variantes de l'invention, d'autres méthodes de ré-échantillonnage sont possibles au codeur, en particulier en utilisant d'autres filtres FIR, des filtres IIR au lieu des filtres FIR, ou encore un banc de filtre par exemple de type QMF. Le principe reste le même.

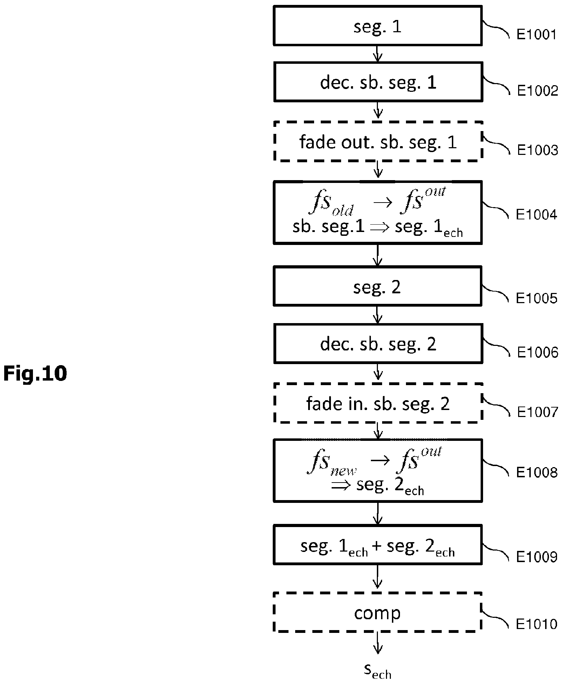

La **figure 10** présente un autre mode de réalisation alternatif, dans lequel le ré-échantillonnage par filtre FIR est remplacé par un banc de filtres de type FIR occasionnant un retard prédéterminé similaire au filtrage FIR. Un exemple de banc de filtre modulé est par exemple donné dans le codec G.729.1 pour la partie d'extraction et d'application de l'enveloppe fréquentielle de l'extension de bande (notée TDBWE pour "Time Domain Bandwidth Extension") mais d'autres mises en oeuvre sont possibles.

Le principe de l'invention reste identique puisqu'on définit dans ce cas deux segments temporels, l'un seg.1 dans la trame précédente décodée CELP (et éventuellement post-filtrée BPF) à la fréquence $fs_{old}$, l'autre seg.2 dans la trame courante décodée CELP (et éventuellement post-filtrée BPF) à la fréquence $fs_{new}$. Des zéros sont ajoutés à droite du segment seg. 1 pour le compléter (dans le « futur »), et des zéros sont ajoutés à gauche du segment seg. 2 pour le compléter (dans le « passé »). Comme dans le cas du filtrage FIR, ces zéros peuvent être ajoutés soit directement en créant un buffer de concaténation soit indirectement en mettant à zéro les mémoires de ré-échantillonnage dans un buffer séparé. Le ré-échantillonnage par banc de filtre est appliqué à ces segments de façon séparée par décomposition en sous-bandes (analyse) en E1002 et E1006 et synthèse par banc de filtre en E1004 et E1008. Les deux segments sont ensuite combinés (ajoutés) sur la partie de recouvrement en E1009.

Dans une variante cette combinaison pourra être réalisée dans le domaine des sous-bandes avant synthèse. La principale différence par rapport au mode de réalisation décrit dans le cas d'un filtrage FIR tient au fait qu'il n'est pas nécessaire de mettre en oeuvre un fondu enchaîné ni de calculer un signal de transition car la décomposition en sous-bandes, si elle est assez fine en terme de nombre de sous-bandes, permet d'effectuer une transition douce par pondération directe des sous-bandes adéquates avant synthèse ; la pondération est appliquée aux sous-bandes associées zone 6.4-8 kHz, soit par atténuation en E1003 soit par augmentation progressive en E1007. La même forme de pondération qu'à la figure 6b peut être réalisée en E1003 et la version « miroir » complémentaire en temporel peut servir en E1007.

Enfin si les bancs des filtres utilisés pour le ré-échantillonnage sont de type modulés les réponses impulsionnelles associées sont en général cohérentes entre trame et dans ce cas la pondération en E1010 n'a pas à être utilisée.

Ainsi, dans ce mode de réalisation, dans le cas où la première fréquence d'échantillonnage est inférieure à la deuxième fréquence d'échantillonnage, l'obtention du second segment ré-échantillonné comporte les étapes suivantes:

- obtention d'une division en sous-bande dans au moins le second segment;
- application d'une fonction de pondération (croissante) sur au moins une sous-bande du second segment ;
- obtention du second segment ré-échantillonné par recombinaison des sous-bandes comportant au moins celle pondérée.

De la même façon, dans le cas où la première fréquence d'échantillonnage est supérieure à la deuxième fréquence d'échantillonnage, l'obtention du premier segment ré-échantillonné comporte les étapes suivantes:

- obtention d'une division en sous-bande dans au moins le premier segment;
- application d'une fonction de pondération (décroissante) sur au moins une sous-bande du premier segment ;
- obtention du premier segment ré-échantillonné par recombinaison des sous-bandes comportant au moins celle pondérée.

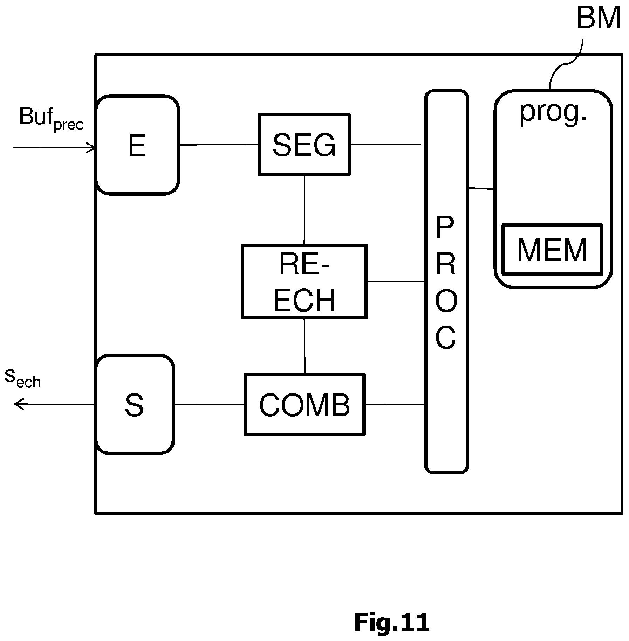

La **figure 11** représente un exemple de réalisation matérielle d'un dispositif de ré-échantillonnage 700 selon l'invention. Celui-ci peut faire partie intégrante d'un codeur, décodeur de signal audiofréquence ou d'un équipement recevant des signaux audiofréquences.

Ce type de dispositif comporte un processeur PROC coopérant avec un bloc mémoire BM comportant une mémoire de stockage et/ou de travail MEM.

Un tel dispositif comporte un module d'entrée E apte à recevoir des trames de signal audio et notamment une partie mémorisée ($Buf_{prec}$) d'une trame précédente à une première fréquence d'échantillonnage $fs_1$.

Il comporte un module de sortie S apte à transmettre une trame courante de signal audio fréquence ré-échantillonné à la fréquence d'échantillonnage de sortie $fs^{out}$.

Le processeur PROC contrôle le module de détermination de segments de signal SEG, apte à déterminer un premier segment de signal par ajout d'un premier nombre prédéterminé d'échantillons à zéro à la fin d'échantillons mémorisés de la trame précédente et un second segment de signal par ajout d'un second nombre prédéterminé d'échantillons à zéro au début d'échantillons de la trame courante.

Le processeur contrôle également un module de ré-échantillonnage RE-ECH apte à appliquer sur le premier segment au moins un filtre de ré-échantillonnage ré-échantillonnant de la première fréquence à la fréquence de sortie et à appliquer au second segment au moins un filtre de ré-échantillonnage ré-échantillonnant de la deuxième fréquence à la fréquence de sortie.

Il contrôle aussi un module de combinaison COMB apte à combiner la partie en recouvrement des premier et second segments ré-échantillonnés pour obtenir la trame courante ré-échantillonné.

Le bloc mémoire peut avantageusement comporter un programme informatique comportant des instructions de code pour la mise en oeuvre des étapes du procédé de ré-échantillonnage au sens de l'invention, lorsque ces instructions sont exécutées par le processeur PROC, et notamment les étapes de détermination d'un premier segment de signal par ajout d'un premier nombre prédéterminé d'échantillons à zéro à la fin d'échantillons mémorisés de la trame précédente, d'obtention du premier segment ré-échantillonné par application sur le premier segment d'au moins un filtre de ré-échantillonnage ré-échantillonnant de la première fréquence à la fréquence de sortie, de détermination d'un second segment de signal par ajout d'un second nombre prédéterminé d'échantillons à zéro au début d'échantillons de la trame courante, d'obtention du second segment ré-échantillonné par application au second segment d'au moins un filtre de ré-échantillonnage ré-échantillonnant de la deuxième fréquence à la fréquence de sortie et de combinaison de la partie en recouvrement des premier et second segments ré-échantillonnés pour obtenir au moins une partie de la trame courante ré-échantillonné.

Typiquement, la description de la figure 3 reprend les étapes d'un algorithme d'un tel programme informatique. Le programme informatique peut également être stocké sur un support mémoire lisible par un lecteur du dispositif ou téléchargeable dans l'espace mémoire de celui-ci.

La mémoire MEM enregistre de manière générale, toutes les données nécessaires à la mise en oeuvre du procédé.

**Revendications**

1. Procédé de ré-échantillonnage d'un signal audiofréquence à une fréquence d'échantillonnage de sortie, pour une trame courante de signal, où la trame précédente est échantillonnée à une première fréquence d'échantillonnage différente d'une deuxième fréquence d'échantillonnage de la trame courante, **caractérisé en ce que** le procédé comporte les étapes suivantes:

   - détermination (E301) d'un premier segment de signal par ajout d'un premier nombre prédéterminé d'échantillons à zéro à la fin d'échantillons mémorisés de la trame précédente;
   - obtention (E302) du premier segment ré-échantillonné par application sur le premier segment d'au moins un filtre de ré-échantillonnage ré-échantillonnant de la première fréquence à la fréquence de sortie;
   - détermination (E303) d'un second segment de signal par ajout d'un second nombre prédéterminé d'échantillons à zéro au début d'échantillons de la trame courante;
   - obtention (E304) du second segment ré-échantillonné par application au second segment d'au moins un filtre de ré-échantillonnage ré-échantillonnant de la deuxième fréquence à la fréquence de sortie;
   - combinaison (E305) de la partie en recouvrement des premier et second segments ré-échantillonnés pour obtenir au moins une partie de la trame courante ré-échantillonnée.

2. Procédé selon la revendication 1, **caractérisé en ce que** dans le cas où la première fréquence d'échantillonnage est inférieure à la deuxième fréquence d'échantillonnage, l'obtention du second segment ré-échantillonné comporte les étapes suivantes:

   - obtention d'un segment de transition par ré-échantillonnage de la deuxième fréquence à la fréquence de sortie, du second segment, sur une bande de fréquence limitée;
   - obtention d'un second segment ré-échantillonné intermédiaire par ré-échantillonnage de la deuxième fréquence à la fréquence de sortie, du second segment;
   - application d'une fonction de fondu enchainé sur au moins une partie des segments de transition et intermédiaire.

3. Procédé selon la revendication 1, **caractérisé en ce que**, dans le cas où la première fréquence d'échantillonnage est inférieure à la deuxième fréquence d'échantillonnage, l'obtention du second segment ré-échantillonné comporte les étapes suivantes:

   - obtention d'une division en sous-bande dans au moins le second segment;
   - application d'une fonction de pondération sur au moins une sous-bande du second segment ;
   - obtention du second segment ré-échantillonné par recombinaison des sous-bandes comportant au moins celle pondérée.

4. Procédé selon la revendication 1, **caractérisé en ce que** dans le cas où la première fréquence d'échantillonnage est supérieure à la deuxième fréquence d'échantillonnage, l'obtention du premier segment ré-échantillonné comporte les étapes suivantes:

   - obtention d'un segment de transition par ré-échantillonnage de la première fréquence à la fréquence de sortie, du premier segment, sur une bande de fréquence limitée;
   - obtention d'un premier segment ré-échantillonné intermédiaire par ré-échantillonnage de la première fréquence à la fréquence de sortie, du premier segment;
   - application d'une fonction de fondu enchainé sur au moins une partie des segments de transition et intermédiaire.

5. Procédé selon l'une des revendications précédentes, **caractérisé en ce qu'**il comporte en outre une étape de multiplication de la trame courante ré-échantillonné résultante de l'étape de combinaison, par un signal de pondération.

6. Procédé de décodage d'une trame courante d'un signal audiofréquence comportant une étape de sélection d'une fréquence d'échantillonnage de décodage, **caractérisé en ce que**, dans le cas où la trame précédente est échantillonné à une première fréquence d'échantillonnage différente d'une deuxième fréquence d'échantillonnage de la trame courante, le procédé comporte un ré-échantillonnage selon un procédé conforme à l'une des revendications 1 à 5.

7. Dispositif de ré-échantillonnage d'un signal audiofréquence à une fréquence d'échantillonnage de sortie, pour une trame courante de signal, où la trame précédente est échantillonnée à une première fréquence d'échantillonnage différente d'une deuxième fréquence d'échantillonnage de la trame courante, **caracterisé en ce que** le dispositif comporte:

- un module (SEG) de détermination d'un premier segment de signal par ajout d'un premier nombre prédéterminé d'échantillons à zéro à la fin d'échantillons mémorisés de la trame précédente;
- un module de ré-échantillonnage (RE-ECH) apte à obtenir un premier segment ré-échantillonné par application sur le premier segment d'au moins un filtre de ré-échantillonnage ré-échantillonnant de la première fréquence à la fréquence de sortie;
- un module (SEG) de détermination d'un second segment de signal par ajout d'un second nombre prédéterminé d'échantillons à zéro au début d'échantillons de la trame courante;
- un module de ré-échantillonnage (RE-ECH) apte à obtenir un second segment ré-échantillonné par application au second segment d'au moins un filtre de ré-échantillonnage ré-échantillonnant de la deuxième fréquence à la fréquence de sortie;
- un module de combinaison (COMB) apte à combiner la partie en recouvrement des premier et second segments ré-échantillonnés pour obtenir au moins une partie de la trame courante ré-échantillonné.

8. Décodeur de signal audiofréquence **caractérisé en ce qu'**il comporte un module de sélection d'une fréquence d'échantillonnage de décodage et un dispositif de ré-échantillonnage conforme à la revendication 7.

9. Programme informatique comportant des instructions de code pour la mise en oeuvre des étapes du procédé de ré-échantillonnage selon l'une des revendications 1 à 5, lorsque ces instructions sont exécutées par un processeur.

10. Support de stockage lisible par un processeur, sur lequel est stocké un programme informatique comprenant des instructions de code pour l'exécution des étapes du procédé de ré-échantillonnage selon l'une des revendications 1 à 5.

**Patentansprüche**

1. Verfahren zum Wiederabtasten eines Audiofrequenzsignals mit einer Ausgangsabtastfrequenz für einen aktuellen Signalrahmen, wobei der vorherige Rahmen mit einer ersten Abtastfrequenz abgetastet wird, die von einer zweiten Abtastfrequenz des aktuellen Rahmens verschieden ist, **dadurch gekennzeichnet, dass** das Verfahren die folgenden Schritte aufweist:

- Bestimmen (E301) eines ersten Signalsegments durch Hinzufügen einer ersten vorbestimmten Anzahl von Nullabtastwerten am Ende von gespeicherten Abtastwerten des vorherigen Rahmens;
- Erhalten (E302) des ersten wieder abgetasteten Segments durch Anwenden auf das erste Segment von mindestens einem wieder abtastenden Wiederabtastfilter der ersten Frequenz mit der Ausgangsfrequenz;
- Bestimmen (E303) eines zweiten Signalsegments durch Hinzufügen einer zweiten vorbestimmten Anzahl von Nullabtastwerten am Anfang von Abtastwerten des aktuellen Rahmens;
- Erhalten (E304) des zweiten wieder abgetasteten Segments durch Anwenden auf das zweite Segment von mindestens einem wieder abtastenden Wiederabtastfilter der zweiten Frequenz mit der Ausgangsfrequenz;
- Kombinieren (E305) des Überlappungsteils des ersten und zweiten wieder abgetasteten Segments, um mindestens einen Teil des wieder abgetasteten aktuellen Rahmens zu erhalten.

2. Verfahren nach Anspruch 1, **dadurch gekennzeichnet, dass**, falls die erste Abtastfrequenz niedriger als die zweite Abtastfrequenz ist, das Erhalten des zweiten wieder abgetasteten Segments die folgenden Schritte aufweist:

- Erhalten eines Übergangssegments durch Wiederabtasten der zweiten Frequenz des zweiten Segments mit der Ausgangsfrequenz über ein begrenztes Frequenzband;
- Erhalten eines zweiten wieder abgetasteten Zwischensegments durch Wiederabtasten der zweiten Frequenz des zweiten Segments mit der Ausgangsfrequenz;
- Anwenden von einer Überblendungsfunktion auf mindestens einen Teil des Übergangssegments und des Zwischensegments.

3. Verfahren nach Anspruch 1, **dadurch gekennzeichnet, dass**, falls die erste Abtastfrequenz niedriger als die zweite Abtastfrequenz ist, das Erhalten des zweiten wieder abgetasteten Segments die folgenden Schritte aufweist:

- Erhalten einer Unterteilung in Unterbänder in mindestens dem zweiten Segment;
- Anwenden von einer Gewichtsfunktion auf mindestens ein Unterband des zweiten Segments;
- Erhalten des zweiten wieder abgetasteten Segments durch Rekombination der Unterbänder, umfassend mindestens jenes, das gewichtet wird.

4. Verfahren nach Anspruch 1, **dadurch gekennzeichnet, dass**, falls die erste Abtastfrequenz höher als die zweite Abtastfrequenz ist, das Erhalten des ersten wieder abgetasteten Segments die folgenden Schritte aufweist:

- Erhalten eines Übergangssegments durch Wiederabtasten der ersten Frequenz des ersten Segments mit der Ausgangsfrequenz über ein begrenztes Frequenzband;
- Erhalten eines ersten wieder abgetasteten Zwischensegments durch Wiederabtasten der ersten Frequenz des ersten Segments mit der Ausgangsfrequenz;
- Anwenden von einer Überblendungsfunktion auf mindestens einen Teil des Übergangssegments und des Zwischensegments.

5. Verfahren nach einem der vorgenannten Ansprüche, **dadurch gekennzeichnet, dass** es ferner einen Schritt des Multiplizierens des wieder abgetasteten aktuellen Rahmens, der aus dem Schritt des Kombinierens hervorgeht, mit einem Gewichtungssignal aufweist.

6. Verfahren zur Decodierung eines aktuellen Rahmens eines Audiofrequenzsignals, umfassend einen Schritt des Auswählens von einer Abtastfrequenz zur Decodierung, **dadurch gekennzeichnet, dass**, falls der vorherige Rahmen mit einer ersten Abtastfrequenz abgetastet wird, die von einer zweiten Abtastfrequenz des aktuellen Rahmens verschieden ist, das Verfahren ein Wiederabtasten nach einem Verfahren gemäß einem der Ansprüche 1 bis 5 aufweist.

7. Vorrichtung zum Wiederabtasten eines Audiofrequenzsignals mit einer Ausgangsabtastfrequenz für einen aktuellen Signalrahmen, wobei der vorherige Rahmen mit einer ersten Abtastfrequenz abgetastet wird, die von einer zweiten Abtastfrequenz des aktuellen Rahmens verschieden ist, **dadurch gekennzeichnet, dass** die Vorrichtung Folgendes aufweist:

- ein Modul (SEG) zum Bestimmen eines ersten Signalsegments durch Hinzufügen einer ersten vorbestimmten Anzahl von Nullabtastwerten am Ende von gespeicherten Abtastwerten des vorherigen Rahmens;
- ein Modul zum Wiederabtasten (RE-ECH), das geeignet ist, ein erstes wieder abgetastetes Segment durch Anwenden auf das erste Segment von mindestens einem wieder abtastenden Wiederabtastfilter der ersten Frequenz mit der Ausgangsfrequenz zu erhalten;
- ein Modul (SEG) zum Bestimmen eines zweiten Signalsegments durch Hinzufügen einer zweiten vorbestimmten Anzahl von Nullabtastwerten am Anfang von Abtastwerten des aktuellen Rahmens;
- ein Modul zum Wiederabtasten (RE-ECH), das geeignet ist, ein zweites wieder abgetastetes Segment durch Anwenden auf das zweite Segment von mindestens einem wieder abtastenden Wiederabtastfilter der zweiten Frequenz mit der Ausgangsfrequenz zu erhalten;
- ein Modul zum Kombinieren (COMB), das geeignet ist, das Überlappungsteil des ersten und zweiten wieder abgetasteten Segments zu kombinieren, um mindestens einen Teil des wieder abgetasteten aktuellen Rahmens zu erhalten.

8. Decoder von Audiofrequenzsignalen, **dadurch gekennzeichnet, dass** er ein Modul zum Auswählen von einer Abtastfrequenz zur Decodierung und eine Vorrichtung zum Wiederabtasten gemäß Anspruch 7 aufweist.

9. Computerprogramm, umfassend Codeanweisungen zum Umsetzen der Schritte des Verfahrens zum Wiederabtasten nach einem der Ansprüche 1 bis 5, wenn diese Anweisungen von einem Prozessor ausgeführt werden.

10. Prozessorlesbares Speichermedium, auf dem ein Computerprogramm gespeichert ist, das Codeanweisungen zum Ausführen der Schritte des Verfahrens zum Wiederabtasten nach einem der Ansprüche 1 bis 5 aufweist.

**Claims**

1. Method for resampling an audio frequency signal at an output sampling frequency, for a current signal frame, where the preceding frame is sampled at a first sampling frequency different from a second sampling frequency of the current frame, **characterized in that** the method comprises the following steps:

   - determination (E301) of a first signal segment by addition of a first predetermined number of samples at zero at the end of stored samples of the preceding frame;
   - obtaining (E302) of the first resampled segment by application to the first segment of at least one resampling filter resampling from the first frequency to the output frequency;
   - determination (E303) of a second signal segment by addition of a second predetermined number of samples at zero at the start of samples of the current frame;
   - obtaining (E304) of the second resampled segment by application to the second segment of at least one resampling filter resampling from the second frequency to the output frequency;
   - combination (E305) of the overlapping part of the first and second resampled segments to obtain at least a part of the current resampled frame.

2. Method according to Claim 1, **characterized in that**, in the case where the first sampling frequency is lower than the second sampling frequency, the obtaining of the second resampled segment comprises the following steps:

   - obtaining of a transition segment by resampling from the second frequency to the output frequency, of the second segment, over a limited frequency band;
   - obtaining of a second intermediate resampled segment by resampling from the second frequency to the output frequency, of the second segment;
   - application of a cross-fading function to at least a part of the transition and intermediate segments.

3. Method according to Claim 1, **characterized in that**, in the case where the first sampling frequency is lower than the second sampling frequency, the obtaining of the second resampled segment comprises the following steps:

   - obtaining of a sub-band division in at least the second segment;
   - application of a weighting function to at least one sub-band of the second segment;
   - obtaining of the second resampled segment by recombination of the sub-bands comprising at least the one that is weighted.

4. Method according to Claim 1, **characterized in that**, in the case where the first sampling frequency is higher than the second sampling frequency, the obtaining of the first resampled segment comprises the following steps:

   - obtaining of a transition segment by resampling from the first frequency to the output frequency, of the first segment, over a limited frequency band;
   - obtaining of a first intermediate resampled segment by resampling from the first frequency to the output frequency, of the first segment;
   - application of a cross-fading function to at least a part of the transition and intermediate segments.

5. Method according to one of the preceding claims, **characterized in that** it further comprises a step of multiplication of the current resampled frame resulting from the combination step, by a weighting signal.

6. Method for decoding a current frame of an audio frequency signal comprising a step of selection of a decoding sampling frequency, **characterized in that**, in the case where the preceding frame is sampled at a first sampling frequency different from a second sampling frequency of the current frame, the method comprises a resampling according to a method conforming to one of Claims 1 to 5.

7. Device for resampling an audio frequency signal at an output sampling frequency, for a current signal frame, where the preceding frame is sampled at a first sampling frequency different from a second sampling frequency of the current frame, **characterized in that** the device comprises:

- a module (SEG) for determining a first signal segment by addition of a first predetermined number of samples at zero at the end of stored samples of the preceding frame;
- a resampling module (RE-ECH) capable of obtaining a first resampled segment by application to the first segment of at least one resampling filter resampling from the first frequency to the output frequency;
- a module (SEG) for determining a second signal segment by addition of a second predetermined number of samples at zero at the start of samples of the current frame;
- a resampling module (RE-ECH) capable of obtaining a second resampled segment by application to the second segment of at least one resampling filter resampling from the second frequency to the output frequency;
- a combination module (COMB) capable of combining the overlapping part of the first and second resampled segments to obtain at least a part of the current resampled frame.

8. Audio frequency signal decoder, **characterized in that** it comprises a module for selecting a decoding sampling frequency and a resampling device conforming to Claim 7.

9. Computer program comprising code instructions for the implementation of the steps of the resampling method according to one of Claims 1 to 5, when these instructions are executed by a processor.

10. Processor-readable storage medium, on which is stored a computer program comprising code instructions for the execution of the steps of the resampling method according to one of Claims 1 to 5.

EP 3 084 959 B1

$x(n)$
$fs^{in}$ → **Tr.** (101) → **Filt.** (102) → **Select.** (103)

**COD freq** (130)

$fs^{in} \to fs_1$ (111) → **COD** $fs_1$ (104)

$fs^{in} \to fs_2$ (112) → **COD** $fs_2$ (105)

(110)

**COD BH** (106)

**M U X** (107)

**Fig.1**

**Fig.2**

EP 3 084 959 B1

seg. 1 — E301

$fs_{old} \rightarrow fs^{out}$ ⟹ seg. $1_{ech}$ — E302

seg. 2 — E303

$fs_{new} \rightarrow fs^{out}$ ⟹ seg. $2_{ech}$ — E304

seg. $1_{ech}$ + seg. $2_{ech}$ — E305

comp — E306

$s_{ech}$

**Fig.3**

**Fig.4**

EP 3 084 959 B1

```
┌─────────────────────────┐
│         seg. 1          │  E501a
└─────────────────────────┘
            ↓
┌─────────────────────────┐
│  fs₁  →  fsᵒᵘᵗ          │  E502a
│  seg. 1 ⟹ seg. tr_ech    │
└─────────────────────────┘
            ↓
┌─────────────────────────┐
│  fs₁  →  fsᵒᵘᵗ          │  E503a
│  seg. 1 ⟹ seg. int_ech   │
└─────────────────────────┘
            ↓
┌─────────────────────────┐
│  fond. seg. tr - seg. int│  E504a
│     ⟹ seg. 1_ech         │
└─────────────────────────┘
            ↓
        seg. 1_ech
```

**Fig.5a**

```
┌─────────────────────────┐
│         seg. 2          │  E501b
└─────────────────────────┘
            ↓
┌─────────────────────────┐
│  fs₂  →  fsᵒᵘᵗ          │  E502b
│  seg. 2 ⟹ seg. tr_ech    │
└─────────────────────────┘
            ↓
┌─────────────────────────┐
│  fs₂  →  fsᵒᵘᵗ          │  E503b
│  seg. 2 ⟹ seg. int_ech   │
└─────────────────────────┘
            ↓
┌─────────────────────────┐
│  fond. seg. tr - seg. int│  E504b
│     ⟹ seg. 2_ech         │
└─────────────────────────┘
            ↓
        seg. 2_ech
```

**Fig.5b**

Fig.6b

Fig.6d

Fig.6a

Fig.6c

Fig.7

E801

$f_{s_1} \rightarrow f_{s_{int}}$  sur-ech $tr_{prec}$

E802

$f_{s_2} \rightarrow f_{s_{int}}$  sur-ech $tr_{cur}$

E803

BPF

E804

$f_{s_{int}} \rightarrow f_{s}^{out}$  ss-ech

E805

comp

$s_{ech}$

**Fig.8**

29

12,8 kHz    16 kHz

64 kHz

64 kHz LP

32 kHz

**Fig.9**

EP 3 084 959 B1

EP 3 084 959 B1

**Fig.10**

seg. 1 — E1001

$\downarrow$

dec. sb. seg. 1 — E1002

$\downarrow$

fade out. sb. seg. 1 — E1003

$\downarrow$

$fs_{old} \rightarrow fs^{out}$
sb. seg.1 $\Rightarrow$ seg. 1$_{ech}$ — E1004

$\downarrow$

seg. 2 — E1005

$\downarrow$

dec. sb. seg. 2 — E1006

$\downarrow$

fade in. sb. seg. 2 — E1007

$\downarrow$

$fs_{new} \rightarrow fs^{out}$
$\Rightarrow$ seg. 2$_{ech}$ — E1008

$\downarrow$

seg. 1$_{ech}$ + seg. 2$_{ech}$ — E1009

$\downarrow$

comp — E1010

$\downarrow$

$s_{ech}$

Fig.11

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060214938 A1

**Littérature non-brevet citée dans la description**

- **G. ROY ; P. KABAL.** Wideband CELP speech coding at 16 kbits/sec. *ICASSP,* 1991
- **C. LAFLAMME et al.** wideband speech coding technique based on algebraic CELP. *ICASSP,* 1991
- **R.W. SCHAFER ; L.R. RABINER.** A Digital Signal Processing Approach to Interpolation. *Proceedings of the IEEE,* Juin 1973, vol. 61 (6), 692-702
- **P.A. REGALIA ; S.K. MITRA ; P.P. VAIDYANATH-AN.** The Digital All-Pass Filter: A Versatile Signal Processing Building Block. *Proceedings of the IEEE,* Janvier 1988, vol. 76 (1